(19) **Europäisches Patentamt / European Patent Office / Office européen des brevets**

(11) **EP 4 592 823 A1**

(12) **EUROPEAN PATENT APPLICATION**

(43) Date of publication:
**30.07.2025 Bulletin 2025/31**

(21) Application number: **24206895.5**

(22) Date of filing: **16.10.2024**

(51) International Patent Classification (IPC):
**G06F 7/544** $^{(2006.01)}$ **G06F 7/483** $^{(2006.01)}$

(52) Cooperative Patent Classification (CPC):
**G06F 7/5443; G06F 7/483;** G06F 2207/4824

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **25.01.2024 KR 20240011775**

(71) Applicants:
- **Samsung Electronics Co., Ltd**
  **Suwon-si, Gyeonggi-do 16677 (KR)**
- **Naver Corporation**
  **Seongnam-si, Gyeonggi-do 13561 (KR)**

(72) Inventors:
- **KIM, Suchang**
  **Suwon-si (KR)**
- **JANG, Jae Hun**
  **Suwon-si (KR)**

- **JEON, Younho**
  **Suwon-si (KR)**
- **PARK, Yeo-Reum**
  **Suwon-si (KR)**
- **LIM, Jihoon**
  **Suwon-si (KR)**
- **SON, Hong Rak**
  **Suwon-si (KR)**
- **LEE, Dongsoo**
  **13529 Seongnam-si (KR)**
- **KWON, Se Jung**
  **13529 Seongnam-si (KR)**
- **KIM, Byeoung Wook**
  **13529 Seongnam-si (KR)**
- **PARK, Baeseong**
  **13529 Seongnam-si (KR)**

(74) Representative: **Marks & Clerk LLP**
**15 Fetter Lane**
**London EC4A 1BW (GB)**

(54) **MULTIPLICATION AND ACCUMULATION OPERATOR AND MATRIX MULTIPLIER INCLUDING THE SAME**

(57) A matrix multiplier includes an input vector scaler configured to generate a scaled input matrix based on a first input matrix and a plurality of scale factors, a first data type converter configured to convert the data type of the scaled input matrix to fixed-point and generate a fixed-point input matrix, a multiplication and accumulation operator array configured to receive the fixed-point input matrix and a plurality of binary vectors, generate a fixed-point output matrix based on the fixed-point input matrix and the plurality of binary vectors, generate the first input matrix and the second input matrix, and generate a first output matrix based on the first input matrix and the second input matrix, and a second data type converter configured to convert the data type of the fixed-point output matrix to a floating point and generate a second output matrix.

FIG. 6

EP 4 592 823 A1

**Description**

BACKGROUND

Various example embodiments relate to a multiplication and accumulation operator and/or a matrix multiplier including the same.

Deep Learning, a field of artificial intelligence, may recognize patterns in complex data and enables sophisticated predictions. In general, deep learning consists of (or includes) a training stage in which a neural network model is trained using training data, and an inference stage in which new data is input into the trained neural network model to obtain an output. Most of the operation time of deep learning is spent on matrix multiplication.

Meanwhile, deep learning may generally be performed using a general-purpose processor such as a graphics processing unit (GPU) and/or neural processing unit (NPU). Recently, a trend of embedding deep learning technology in mobile or internet of things (IoT) application devices is accelerating, and technology is needed or desired to implement the large amount of computing power required or used by deep learning in small semiconductors.

SUMMARY

Various example embodiments may attempt to provide a multiplication and accumulation (MAC) operator configured to be implemented in a small semiconductor device, and/or a matrix multiplier including the same.

Alternatively or additionally, various example embodiments may attempt to provide a multiplication and accumulation (MAC) operator implemented as a single piece of hardware and configured to perform a multiplication operation on a plurality of input matrices, and/or a multiplication operation on an input matrix and a weight matrix, and/or a matrix multiplier including the same.

A matrix multiplier according to various example embodiments may include an input vector scaler configured to generate a scaled input matrix based on a first input matrix and on a plurality of scale factors, a first data type converter configured to convert the data type of the scaled input matrix to fixed-point and to generate a fixed-point input matrix, a multiplication and accumulation operator array configured to receive the fixed-point input matrix and a plurality of binary vectors, to generate a fixed-point output matrix based on the fixed-point input matrix and the plurality of binary vectors, to generate the first input matrix and the second input matrix, and to generate a first output matrix based on the first input matrix and on the second input matrix, and a second data type converter configured to convert the data type of the fixed-point output matrix to a floating point and to generate a second output matrix.

Alternatively or additionally, a MAC operator according to various example embodiments may include a first multiplexer configured to receive mantissa data of first data of a first data type and of second data of a second data type different from the first data type, to output the first data based on a first signal, and to output mantissa data of the second data based on a second signal different from the first data, a first AND operation unit configured to receive a plurality of binary values and to perform an AND operation of a first binary value among the plurality of binary values and the first data, and an adder configured to add output data of the first AND operation unit and to output first output data of the first data type.

Alternatively or additionally a matrix multiplier according to various example embodiments may include a data buffer configured to receive a first input vector and a second input vector from an external memory, and to receive a plurality of scale factors and a plurality of binary vectors as weight vectors from the external memory, an input parser configured to receive the plurality of scale factors and the plurality of binary vectors, to output the plurality of scale factors and the plurality of binary vectors together with a first signal of a first level, to receive the second input vector, and to output the second input vector together with a first signal of a second level different from the first level, an input vector scaler configured to generate a first scaled input vector based on a multiplication operation on the first input vector and on the plurality of scale factors, a first data type converter configured to receive the first scaled input vector, to extract a first exponent among the exponents of each of the first plurality of scaled input elements included in the first scaled input vector, and to convert the data type of the first scaled input vector to fixed-point based on the first exponent, and a MAC operator configured to accumulate the first scaled input vector based on the binary values of the plurality of binary vectors and generate a fixed-point output matrix when receiving the first signal of the first level.

At least some of the above and other features of the invention are set out in the claims.

BRIEF DESCRIPTION OF THE DRAWINGS

FIG. 1 is a block diagram of a matrix multiplier according to some example embodiments.
FIG. 2 illustrates a weight matrix WM of FIG. 1.
FIG. 3 illustrates floating point data as a data format.

FIG. 4 illustrates a multiplication and accumulation operator.

FIG. 5 illustrates an operation method of a mantissa operation unit of FIG. 4.

FIG. 6 is a block diagram illustrating the configuration of the matrix multiplier of FIG. 1.

FIG. 7 is a block diagram of an input vector scaler according to some example embodiments.

FIG. 8 illustrates the operation of an input vector scaling circuit of FIG. 7.

FIG. 9 is a block diagram of a first data type converter according to some example embodiments.

FIG. 10 illustrates a method for extracting an exponent by the first data type converter of FIG. 9.

FIG. 11 illustrates an operation method of converting the data type of a received input vector into a fixed-point based on the exponent extracted by the first data type converter of FIG. 10.

FIG. 12 is a block diagram of a multiplication and accumulation operator array according to some example embodiments.

FIG. 13 illustrates an operation method of a multiplication and accumulation operator according to some example embodiments.

FIG. 14 illustrates an operation method of a multiplication and accumulation operator according to some example embodiments.

FIG. 15 illustrates an operation method of a multiplication and accumulation operator according to some example embodiments.

FIG. 16 is a block diagram of a mantissa operation unit of a multiplication and accumulation operator according to some example embodiments.

FIG. 17 is a block diagram of a multiplication and accumulation operator according to some example embodiments.

FIG. 18 illustrates the operation of a second data type converter according to some example embodiments.

FIG. 19 is a block diagram showing a neural processing system according to some example embodiments.

FIG. 20 illustrates an example of a multi-head attention according to some example embodiments.

FIG. 21 illustrates an example of a scaled dot-product attention of FIG. 20.

DETAILED DESCRIPTION OF VARIOUS EXAMPLE EMBODIMENTS

In the following detailed description, only certain example embodiments have been shown and described, simply by way of illustration. As those of ordinary skill in the art may realize, the described example embodiments may be modified in various different ways, all without departing from the scope of inventive concepts.

Accordingly, the drawings and description are to be regarded as illustrative in nature and not restrictive. Like reference numerals designate like elements throughout the specification. In the flowchart described with reference to drawings in this description, the operation order may be changed, several operations may be merged, certain operations may be divided, and specific operations may not be performed.

In the description, expressions described in the singular in this specification may be interpreted as the singular or plural unless an explicit expression such as "one" or "single" is used. Although terms of "first," "second," and the like are used to explain various constituent elements, the constituent elements are not limited to such terms. These terms are only used to distinguish one constituent element from another constituent element.

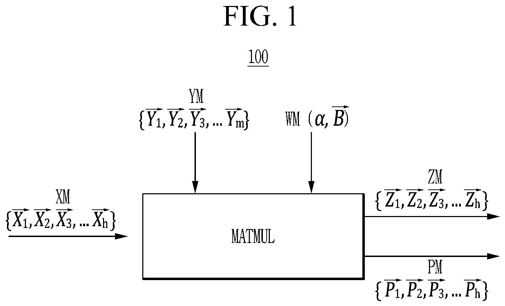

FIG. 1 is a block diagram of a matrix multiplier according to some example embodiments. Referring to FIG. 1, a matrix multiplier MATMUL 100 may receive a plurality of input matrices XM and YM. Each of the input matrices XM and YM may include a plurality of input vectors. Each of the plurality of input vectors may include a plurality of input elements. For example, the first input matrix XM among the plurality of input matrices XM and YM may be represented by Equation 1 below.

$$\text{(Equation 1)}$$

$$XM = \begin{bmatrix} \overrightarrow{X_1} \\ \overrightarrow{X_2} \\ \vdots \\ \overrightarrow{X_h} \end{bmatrix} = \begin{bmatrix} x_{11} & x_{12} & \cdots & x_{1n} \\ x_{21} & x_{22} & \cdots & x_{2n} \\ \vdots & \vdots & \ddots & \vdots \\ x_{h1} & x_{h2} & \cdots & x_{hn} \end{bmatrix}$$

Referring to Equation 1, XM may represent the first input matrix XM, $\overrightarrow{X_1}$ to $\overrightarrow{X_h}$ may represent the first to (h)th input vectors, respectively, and $x_{11}$ to $x_{hn}$ may represent different input elements. For example, $x_{11}$ to $x_{1n}$ may represent input elements included in the first input vector $\overrightarrow{X_1}$, and $x_{h1}$ to $x_{hn}$ may represent input elements included in the (h)th input vector $\overrightarrow{X_h}$. In various example embodiments, h may be greater than, less than, or equal to n.

The second input matrix YM among the plurality of input matrices XM and YM may be represented by Equation 2

below.

(Equation 2)

$$YM = [\overrightarrow{Y_1} \quad \overrightarrow{Y_2} \quad ... \quad \overrightarrow{Y_m}] = \begin{bmatrix} y_{11} & y_{12} & \cdots & y_{1m} \\ y_{21} & y_{22} & \cdots & y_{2m} \\ \vdots & \vdots & \ddots & \vdots \\ y_{n1} & y_{n2} & \cdots & y_{nm} \end{bmatrix}$$

Referring to Equation 2, YM may represent the second input matrix YM, the second input matrix YM may include the first input vector $\overrightarrow{Y_1}$ to the (m)th input vector $\overrightarrow{Y_m}$, and each input vector may include different input elements from $y_{11}$ to $y_{nm}$. For example, the first input vector $\overrightarrow{Y_1}$ may include different input elements from $y_{11}$ to $y_{n1}$, and the (m)th input vector $\overrightarrow{Y_m}$ may include different input elements from $y_{1m}$ to $y_{nm}$. In various example embodiments, m may be less than, greater than, or equal to n.

In some example embodiments, each of the input elements or entries included in the input matrices XM and YM may be floating point data. For example, the data type of each input element included in the input matrices XM and YM may be FP16 (16-bits floating point), or alternatively, may be FP32 (32-bits floating point). However, example embodiments are not limited thereto. In some cases, the data type of the input elements XM and YM may be heterogeneous; example embodiments are not limited thereto.

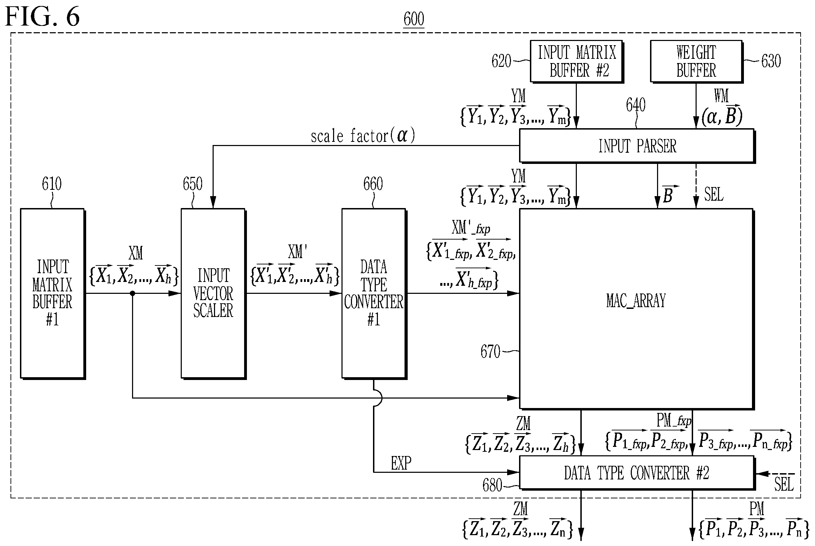

In some example embodiments, the matrix multiplier 100 may perform matrix multiplication on the first input matrix XM and the second input matrix YM. The matrix multiplication may be based on a Strassen algorithm and/or a divide-and-conquer algorithm and/or on various other matrix multiplication algorithms; example embodiments are not limited thereto. The matrix multiplier 100 may perform a multiplication operation on the first input matrix XM and the second input matrix YM, and may generate a first output matrix ZM. For example, the matrix multiplier 100 may generate the first output matrix ZM by performing floating point multiplication of the input elements of the first input matrix XM and the second input matrix YM, and then performing floating point summation of the multiplication results. A method of performing multiplication of the first input matrix XM and the second input matrix YM of the matrix multiplier 100 according to some example embodiments will be described later with reference to FIGS. 6 and 12 to 14.

The first output matrix ZM may include a plurality of output vectors. Each of the plurality of output vectors may include a plurality of output elements. For example, the first output matrix ZM may be represented by Equation 3 below.

(Equation 3)

$$ZM = \begin{bmatrix} \overrightarrow{Z_1} \\ \overrightarrow{Z_2} \\ \vdots \\ \overrightarrow{Z_h} \end{bmatrix} = \begin{bmatrix} z_{11} & z_{12} & \cdots & z_{1m} \\ z_{21} & z_{22} & \cdots & z_{2m} \\ \vdots & \vdots & \ddots & \vdots \\ z_{h1} & z_{h2} & \cdots & z_{hm} \end{bmatrix}$$

In this case, ZM may represent the first output matrix ZM, and each of $z_{11}$ to $z_{hm}$ may represent different output elements. For example, $z_{11}$ to $z_{1m}$ may represent output elements included in the first output vector $\overrightarrow{Z_1}$, and $z_{h1}$ to $z_{hm}$ may represent output elements included in the (h)th output vector $\overrightarrow{Z_h}$.

In some example embodiments, the matrix multiplier 100 may further receive a weight matrix WM. The weight matrix WM may include a plurality of weights. For example, the weight matrix WM may be represented by Equation 4 below.

(Equation 4)

$$WM = \begin{bmatrix} w_{11} & w_{12} & \cdots & w_{1m} \\ w_{21} & w_{22} & \cdots & w_{2m} \\ \vdots & \vdots & \ddots & \vdots \\ w_{n1} & w_{n2} & \cdots & w_{nm} \end{bmatrix}$$

Referring to Equation 4, WM may represent a weight matrix WM, and each of $w_{11}$ to $w_{nm}$ may represent a different weight. For example, $w_{ij}$ may be a weight disposed in the (i)th row and (j)th column of the weight matrix WM. In some example embodiments, each weight included in the weight matrix WM may be floating point data. For example, the data type of each weight may be FP16 and/or FP32. However, example embodiments are not limited thereto.

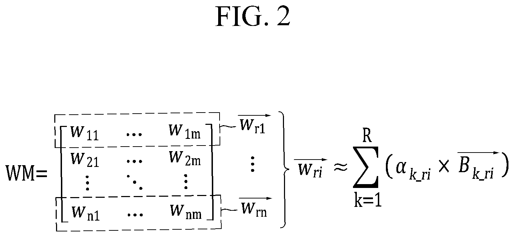

In some example embodiments, the weights of the weight matrix WM may be approximated with a plurality of scale factors ($\alpha$) and binary values b. The matrix multiplier 100 may receive a plurality of scale factors ($\alpha$) and binary values b as weights of the weight matrix WM. A detailed description of the plurality of scale factors ($\alpha$) and binary values b will be described later with reference to FIG. 2.

In some example embodiments, the matrix multiplier 100 may perform matrix multiplication on the first input matrix XM and the weight matrix WM. For example, the matrix multiplier 100 may be implemented to operate the output elements by first multiplying the input elements of the first input matrix XM with the scale factor ($\alpha$), and then accumulating the operated product based on the binary value b. A method of performing multiplication of the first input matrix XM and the weight matrix WM of the matrix multiplier 100 according to some example embodiments will be described later with reference to FIGS. 6 to 17.

In some example embodiments, the matrix multiplier 100 may multiply the first input matrix XM and the weight matrix WM to generate a second output matrix PM. The second output matrix PM may include a plurality of output vectors. Each of the plurality of output vectors may include a plurality of output elements. For example, the second output matrix PM may be represented by Equation 5 below.

$$\text{(Equation 5)}$$

$$PM = \begin{bmatrix} \overrightarrow{P_1} \\ \overrightarrow{P_2} \\ \vdots \\ \overrightarrow{P_h} \end{bmatrix} = \begin{bmatrix} p_{11} & p_{12} & \cdots & p_{1m} \\ p_{21} & p_{22} & \cdots & p_{2m} \\ \vdots & \vdots & \ddots & \vdots \\ p_{h1} & p_{h2} & \cdots & p_{hm} \end{bmatrix}$$

In this case, PM may represent the second output matrix PM, and each of $p_{11}$ to $p_{hm}$ may represent different output elements. For example, $p_{11}$ to $p_{1m}$ may represent output elements included in the first output vector $\overrightarrow{P_1}$, and $p_{h1}$ to $p_{hm}$ may represent output elements included in the (h)th output vector $\overrightarrow{P_h}$.

The matrix multiplier 100 according to some example embodiments may perform a multiplication operation on a plurality of input matrices XM and YM, and output a first output matrix ZM. The matrix multiplier 100 according to some example embodiments may perform a multiplication operation on the input matrix XM and the weight matrix WM, and output the second output matrix PM. The matrix multiplier 100 according to some example embodiments may be implemented as a single piece of hardware and may perform a multiplication operation on a plurality of input matrices and a multiplication operation on the input matrix and the weight matrix. Since a neural processing system that performs deep learning includes a matrix multiplier according to various example embodiments, the area occupied by the matrix multiplier in the neural processing system may be reduced.

When the area of a matrix multiplier is reduced, there may be an improvement in, for example, an integration density and/or a power consumption of a circuit that implements the matrix multiplier. Alternatively or additionally, a yield of a circuit that implements a matrix multiplier according to various example embodiments may be increased. Alternatively or additionally, reliability of a circuit that implements a matrix multiplier according to various example embodiments may be increased.

FIG. 2 illustrates a weight matrix WM of FIG. 1. As described with reference to FIG. 1, the matrix multiplier 100 may receive a plurality of scale factors ($\alpha$) and binary values b as weights of the weight matrix WM.

By quantization of the weight matrix WM, each of the plurality of weights may be converted into a plurality of scale factors ($\alpha$) and binary values b. In various example embodiments, in order to improve the calculation speed of the first input matrix XM and the weight matrix WM, a quantization operation may be performed on the weight matrix WM. By a quantization operation on the weight matrix WM, the weights included in the weight matrix WM may be approximated to a plurality of quantum levels QL. The number of a plurality of quantum levels QL may be determined by a predetermined quantization resolution. For example, each of the plurality of weights may be approximated to $2^R$ (where R is the quantization resolution) quantum levels QL through a quantization operation. In this case, each of the $2^R$ quantum levels QL may be determined based on a combination of R scale factors ($\alpha$) and R binary values b.

In some example embodiments, the weight matrix WM may include a plurality of row vectors. Referring to FIG. 2, the weight matrix WM may include a first row vector $\overrightarrow{w_{r1}}$ to an (n)th row vector $\overrightarrow{w_{rn}}$. In some example embodiments, the weight matrix WM may be quantized row by row. Specifically, $\alpha_{k\_rj}$ may represent the (k)th scale factor for the (j)th row vector $\overrightarrow{w_{rj}}$ of the weight matrix WM. In this case, the scale factor for the weights included in the first row of the weight matrix WM may be different from the scale factor for the weights included in the second row of the weight matrix WM. In some example embodiments, each of the plurality of scale factors ($\alpha$) may have the same data type as the weight of the weight matrix WM. For example, the data type of each of the plurality of scale factors ($\alpha$) may be FP16 and/or FP32. However, example embodiments are not limited thereto.

In some example embodiments, $\overrightarrow{B_{k\_rj}}$ may represent a binary vector corresponding to the (k)th scale factor $\alpha_{k\_rj}$ of the (j)th row vector $\overrightarrow{w_{rj}}$. $\overrightarrow{B_{k\_rj}}$ is a sign value corresponding to the (k)th scale factor $\alpha_{k\_rj}$ of the (j)th row vector $\overrightarrow{w_{rj}}$, and may include a plurality of binary values b.

The binary vector $\overrightarrow{B_{k\_rj}}$ may be implemented as a row vector with the same dimension as the number of columns of the weight matrix WM. For example, $\overrightarrow{B_{k\_rj}}$ may be represented by Equation 6 below.

$$(\text{Equation 6})$$

$$\overrightarrow{B_{k\_rj}} = [b_{1\_k\_rj} \quad b_{2\_k\_rj} \quad \dots \quad b_{m\_k\_rj}]$$

$b_{1\_k\_rj}$ to $b_{m\_k\_rj}$ may each represent a different binary value b, e.g., a value with entries chosen from {'0','1'}. Specifically, $b_{1\_k\_rj}$ to $b_{m\_k\_rj}$ may each be a binary value b for weights disposed in different columns of the weight matrix WM. $b_{1\_k\_rj}$ to $b_{n\_k\_rj}$ may each be '0' or '1'.

As described above, each weight of the weight matrix WM may be approximated based on a plurality of scale factors ($\alpha$) and a plurality of binary values b. Here, it has been described that the weight matrix WM is quantized for each row, but it is not limited thereto, and the weight matrix WM may be quantized for each column.

In some example embodiments, the matrix multiplier 100 may receive a plurality of scale factors ($\alpha$) and binary values b as weights of the weight matrix WM. In some example embodiments, the matrix multiplier 100 may perform a multiplication operation on the first input matrix XM and a plurality of scale factors ($\alpha$) and binary values b, and may generate the second output matrix PM. For example, the matrix multiplier 100 may be implemented to output elements by first multiplying the elements of the first input matrix XM with the scale factor ($\alpha$), and then by accumulating the operated product based on the binary value b. A detailed operation method of this matrix multiplier 100 will be described later with reference to FIGS. 6 to 17.

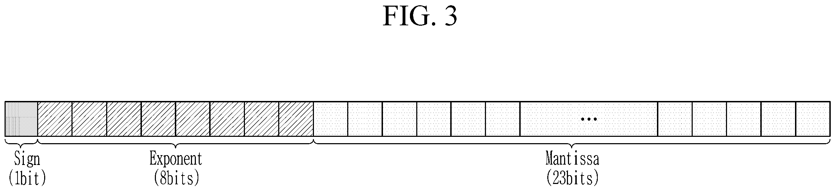

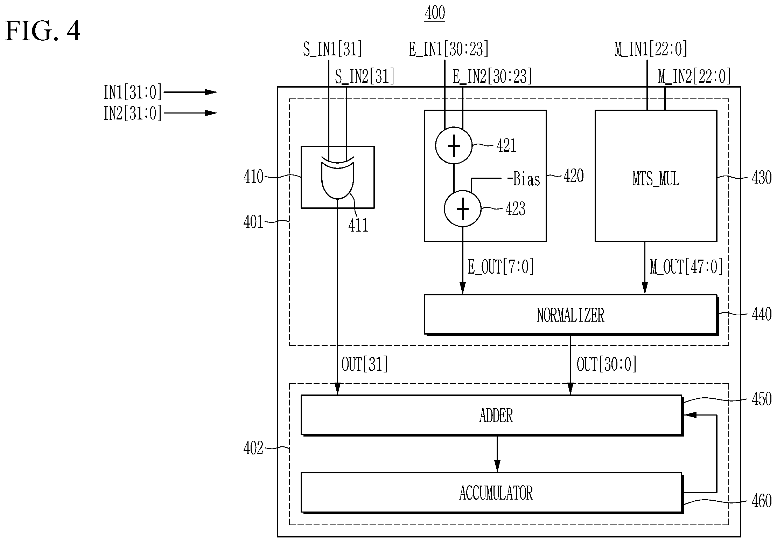

FIGS. 3 and 4 illustrate an operation method of the multiplication and accumulation operator. FIG. 3 illustrates floating point data as a data format, and FIG. 4 illustrates a multiplication and accumulation operator.

As described above, each of the input elements of the input matrices XM and YM and the weights of the weight matrix WM may be floating point data.

Referring to FIG. 3, floating point data may come in various forms depending on precision, but may be implemented using the IEEE 754 standard. The IEEE 754 standard displays real numbers by dividing them into a sign s, an exponent e, and a mantissa. For example, floating point data may be represented by Equation 7 below.

$$(\text{Equation 7})$$

$$x = -1^{s} \times \text{mantissa} \times 2^{e}$$

In single precision, floating point data uses a total of 32 bits (FP32). Specifically, the sign (e.g., the most significant bit) is a single bit, which represents the sign of the data, and may be '0' when the sign is a positive number and '1' when the sign is a negative number. The exponent may be 8 bits and represents the exponent, and the mantissa may be the (least significant) 23 bits and represents the mantissa or significant digits.

For example, representing -314.625 in IEEE 754 floating point format is as follows:

First, since the sign is negative, s becomes '1'.

Regarding the mantissa, if the absolute value of the number, 314.625, is represented in binary, it becomes $100111010.101_{(2)}$. At this time, if the decimal point is moved to the left so that only 1 remains on the left of the decimal point, it may be represented as follows, and this is called a normalized representation method.

$$100111010.101_{2} = 1.00111010101_{2} \times 2^{8}$$

Here, the mantissa is the part to the right of the decimal point, that is, 00111010101.

Regarding the exponent, in the normalized representation of -314.625, the exponent is 8, and adding the bias value of 127 to the exponent 8 becomes 135. At this time, when 135 is converted to binary, it becomes $10000111_{(2)}$, and this value becomes the exponent.

Although single precision is described here as an example, in half precision or double precision, the bits and bias values of the exponent and mantissa may be different. Hereinafter, the description will be made assuming that the data type of the input elements of the input matrices XM and YM and the scale factor ($\alpha$) of the weight matrix WM is FP32.

FIG. 4 illustrates a multiplication and accumulation operator.

A multiplication and accumulation operator 400 may receive floating point data as input data and perform multiplication and accumulation operations on the input data. Hereinafter, the operation method of the multiplication and accumulation operator 400 will be described in detail.

Referring to FIG. 4, the multiplication and accumulation operator 400 may receive a first input data IN1[31:0] and a second input data IN2[31:0], and may perform multiplication and accumulation operations on the input data. For example, when the first input data IN1[31:0] and the second input data IN2[31:0] are 32-bit floating point data, the first input data IN1[31:0] and the second input data IN2[31:0] may each include 1-bit sign data S_IN1[31] and S_IN2[31], 8-bit of exponent data E_IN1[30:23] and E_IN2[30:23), and 23-bit of mantissa data M_IN1[22:0] and M_IN2[22:0].

The multiplication and accumulation operator 400 may include a multiplication portion 401 and an accumulation portion 402. The multiplication portion 401 may include a sign operation unit 410, an exponent operation unit 420, and a mantissa operation unit 430, and the accumulation portion 402 may include an adder 450 and an accumulator 460.

Looking at the multiplication portion 401, the sign operation unit 410 may include an exclusive OR (XOR) operation unit 411. The sign operation unit 410 may receive the first sign data S_IN1[31] of the first input data IN1 and the second sign data S_IN2[31] of the second input data IN2. When both the first sign data S_IN1[31] and the second sign data S_IN2[31] have a value of "0" representing a positive number or a value of "1" representing a negative number, the XOR operation unit 411 of the sign operation unit 410 may output "0" representing a positive number (for example, because a positive number times a positive number is positive, and a negative number times a negative number is positive). On the other hand, when one of the first sign data S_IN1[31] and the second sign data S_IN2[31] has a value of "0" representing a positive number and the other has a value of "1" representing a negative number, the XOR operation unit 411 of the sign operation unit 410 may output "1" representing a negative number (for example, because a positive number times a negative number is negative, and a negative number times a positive number is negative). The sign operation unit 410 may output data generated as a result of the XOR operation as 1-bit sign data OUT[31] of the output data OUT.

The exponent operation unit 420 may include a first exponent adder 421 and a second exponent adder 423. The first exponent adder 421 may receive the first exponent data E_IN1[30:23] of the first input data IN1 and the second exponent data E_IN2[30:23] of the second input data IN2. The first exponent adder 421 may perform a first addition operation on the first exponent data E_IN1[30:23] and the second exponent data E_IN2[30:23]. The first exponent adder 421 may output first addition result data generated as a result of the first addition operation. The first exponent data E_IN1 [30:23] and the second exponent data E_IN2[30:23] are each added with an exponent bias value, for example, "127". As the exponent bias value is doubled by the first addition operation in the first exponent adder 421, example embodiments subtract the exponent bias value from the first addition result data. Accordingly, the second exponent adder 423 may receive the first addition result data output from the first exponent adder 421 and perform the second addition operation of subtracting an exponent bias value, such as "127", from the first addition result data. The second exponent adder 423 may output data generated as a result of the second addition operation as 8-bit exponent data E_OUT[7:0].

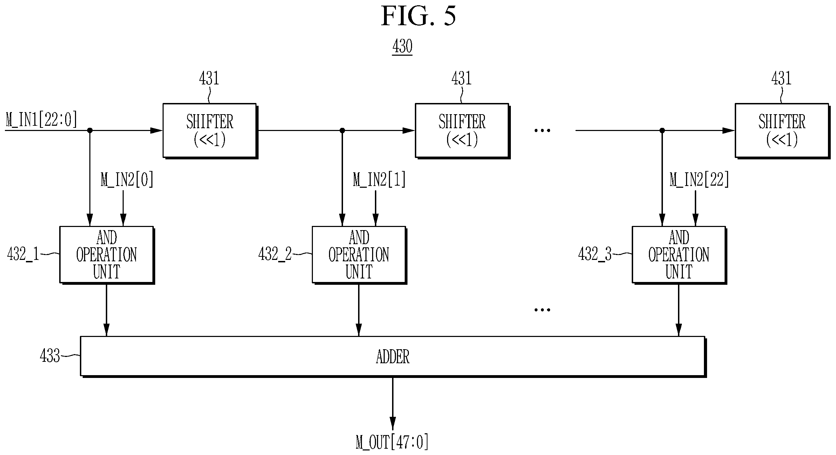

The mantissa operation unit MTS_MUL, 430 may perform a multiplication operation on mantissa data. The mantissa operation unit 430 may receive the first mantissa data M_IN1[22:0] of the first input data IN1 and the second mantissa data M_IN2[22:0] of the second input data IN2. The mantissa operation unit 430 may perform a multiplication operation on the first mantissa data M_IN1[22:0] and the second mantissa data M_IN2[22:0]. The mantissa operation unit 430 may output data generated as a result of the multiplication operation as 48-bit mantissa data M_OUT[47:0]. The specific operation method of the mantissa operation unit 430 will be described later with reference to FIG. 5.

A normalizer 440 may normalize the exponent data E_OUT[7:0] output from the exponent operation unit 420 and the mantissa data M_OUT[47:0] output from the mantissa operation unit 430. Normalization may refer to shifting the calculated data so that the most significant bit becomes 1. A normalized data OUT[30:0] may be output to the accumulation portion 402 as a multiplier result value OUT together with the sign data OUT[31] output from the sign processing circuit 410.

Looking at the accumulation portion 402, the adder 450 may perform an accumulation operation by adding the data received from the multiplication portion 401 and the data received from the accumulator 460.

FIG. 5 illustrates an operation method of a mantissa operation unit of FIG. 4. In general, binary multiplication may be performed with bit shifts and addition operations. The mantissa operation unit 430, which performs binary multiplication, may be implemented as a shifter 431, an AND operation unit 432, and an adder 433.

Referring to FIG. 4 and FIG. 5 together, the mantissa operation unit 430 may receive the first mantissa data M_IN1[22:0] as a multiplicand and receive the second mantissa data M_IN2[22:0] as a multiplier. The data obtained from the first mantissa data M_IN1[22:0] and the second mantissa data M_IN2[22:0], based on each bit M_IN2[0], M_IN2[1], ..., M_IN2[22], may be input into the adder 433 after an AND operation.

The adder 433 may output mantissa data M_OUT[47:0].

In some example embodiments, the lowermost bit M_IN2[0] of the first mantissa data M_IN1[22:0] and the second mantissa data M_IN2[22:0] may be input to a first AND operation unit 432_1. The first AND operation unit 432_1 may output the first mantissa data M_IN1[22:0] as is based on the lowermost bit M_IN2[0] of the second mantissa data M_IN2[22:0], or data in which all bits are '0'. For example, if the lowermost bit M_IN2[0] of the second mantissa data M_IN2[22:0] is '1', the first AND operation unit 432_1 may output the first mantissa data M_IN1[22:0] as is. If the lowermost bit M_IN2[0] of the second mantissa data M_IN2[22:0] is '0', the first AND operation unit 432_1 may output data in which all bits are '0'.

In some example embodiments, the first mantissa data M_IN1[22:0] may be left-shifted by 1 bit by the shifter 431. The left-shifted first mantissa data M_IN1[22:0] by a shifter 421 may be input to AND operation units 432_2, ..., 432_3 together with each bit M_IN2[1], ..., M_IN2[22] of the second mantissa data M_IN2[22:0].

In various example embodiments, data output by the AND operation unit 432 may be input to the adder 433. The adder 433 may perform addition operations on input data sequentially or all at once. The adder 433 may output 48-bit mantissa data M_OUT[47:0] as a result of multiplication of the first mantissa data M_IN1[22:0] and the second mantissa data M_IN2[22:0]. Here, the mantissa operation unit 430 is shown as including one adder, but it is not limited thereto, and the mantissa operation unit 430 may include a plurality of adders connected to each AND operation unit 433.

FIG. 6 is a block diagram illustrating the configuration of the matrix multiplier of FIG. 1. Specifically, the matrix multiplier 100 of FIG. 1 may be implemented as a matrix multiplier 600.

In some example embodiments, the matrix multiplier 600 may include a first input matrix buffer (input matrix buffer #1, 610), a second input matrix buffer (input matrix buffer #2, 620), a weight buffer 630, an input parser 640, an input vector scaler 650, a first data type converter (data type converter #1, 660), a multiplication and accumulation operator array (MAC_ARRAY, 670), and a second data type converter (data type converter #2, 680).

In various example embodiments, the first input matrix buffer 610 and the second input matrix buffer 620 may store input matrices provided from outside. For example, the first input matrix buffer 610 and the second input matrix buffer 620 may receive the first input matrix XM and the second input matrix YM respectively from external memory, and may provide the first input matrix XM and the second input matrix YM to the input vector scaler 650 and the multiplication and accumulation operator array 670.

In some example embodiments, the weight buffer 630 may store a plurality of scale factors ($\alpha$) and binary values b provided from the outside. The weight buffer 630 may store a plurality of scale factors ($\alpha$) and binary values b as weights of the weight matrix WM. For example, the weight buffer 630 may receive a plurality of scale factors ($\alpha$) and binary values b from the outside, and may provide the plurality of scale factors ($\alpha$) and binary values b to the input vector scaler 650 and the multiplication and accumulation operator array 670.

In some example embodiments, the input parser 640 may receive the second input matrix YM from the second input matrix buffer 620, or a plurality of scale factors ($\alpha$) and a binary value b from the weight buffer 630. The input parser 640 may parse the second input matrix YM or a plurality of scale factors ($\alpha$) and binary values b, and may provide the plurality of scale factors ($\alpha$) and binary values b to the input vector scaler 650 or the multiplication and accumulation operator array 670.

In some example embodiments, the second input matrix buffer 620 and the weight buffer 630 may be implemented as one data buffer. Hereinafter, it is assumed that the input parser 640 receives the second input matrix YM from the second input matrix buffer 620 and receives a plurality of scale factors ($\alpha$) and binary values b from the weight buffer 630, but example embodiments are not limited thereto. The input parser 640 may receive the second input matrix YM, a plurality of scale factors ($\alpha$), and a binary value b from a data buffer implemented as one.

In some example embodiments, when the input parser 640 receives the second input matrix YM from the second input matrix buffer 620, the input parser 640 may provide the second input matrix YM to the multiplication and accumulation operator array 670, such that the multiplication and accumulation operator in the multiplication and accumulation operator array 670 performs matrix multiplication on the first input matrix XM and the second input matrix YM.

In some example embodiments, when the input parser 640 receives a plurality of scale factors ($\alpha$) and a binary value b from the weight buffer 630, the input parser 640 may provide the plurality of scale factors ($\alpha$) to the input vector scaler 650 and the plurality of binary values b to the multiplication and accumulation operator array 670, such that a multiplication operation on the first input matrix XM, the plurality of scale factors ($\alpha$) and binary values b is performed. The input vector scaler 650 may perform a multiplication operation on a plurality of scale factors ($\alpha$) and the first input matrix (XM) and output a scaled input matrix XM'.

In some example embodiments, the multiplication and accumulation operator array 670 may include a plurality of multiplication and accumulation operators. The multiplication and accumulation operator array 670 may receive a fixed-point input matrix XM'$_{-fxp}$ in which the data type of the scaled input matrix XM' is converted to fixed-point from the first data type converter 660. In some example embodiments, the input parser 640 may output a control signal SEL at a first level (e.g., high level) to the multiplication and accumulation operator array 670, such that the multiplication and accumulation operator in the multiplication and accumulation operator array 670 performs multiplication operations on the fixed-point input matrix XM'$_{-fxp}$ and the binary value b.

The multiplication and accumulation array 670 may perform multiplication operations on the fixed-point input matrix XM'$_{-fxp}$ and a binary value b by accumulating the elements of the fixed-point input matrix XM'$_{-fxp}$ based on the binary value b, and may output a fixed-point output matrix PM$_{-fxp}$.

In some example embodiments, the input parser 640 may output the control signal SEL at a second level (e.g., low level) to the multiplication and accumulation operator array 670, such that the multiplication and accumulation operator in the multiplication and accumulation operator array 670 performs matrix multiplication on the first input matrix XM and the second input matrix YM. The multiplication and accumulation operator array 670 may perform multiplication and accumulation operations on the input elements of the first input matrix XM and the input elements of the second input matrix YM, and output the first output matrix ZM.

In some example embodiments, the input parser 640 may output the control signal SEL to the second data type converter 680 such that the second data type converter 680 converts the data format of the output elements of the multiplication and accumulation operator array 670. The second data type converter 680 may convert the fixed-point output matrix $PM_{-fxp}$ into the second output matrix PM in a floating point data format based on the control signal SEL of the first level.

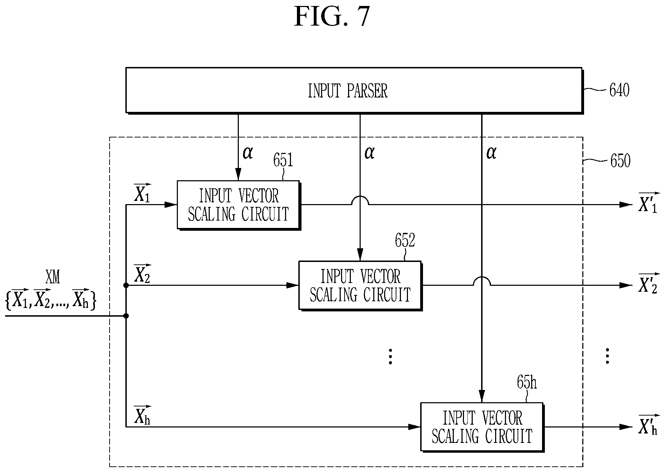

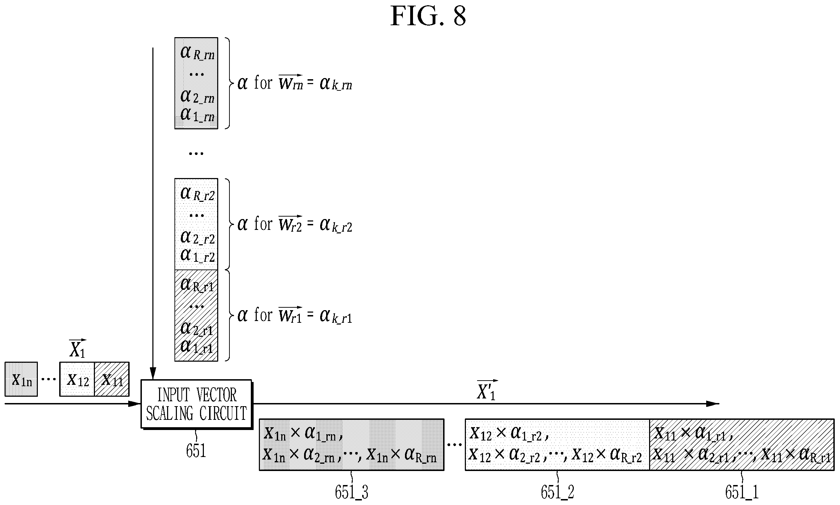

In some example embodiments, the input vector scaler 650 may receive the first input matrix XM. For example, the input vector scaler 650 may receive a plurality of input vectors (e.g., $\vec{X_1}$ to $\vec{X_h}$) including a plurality of input elements. The input vector scaler 650 may scale the first input matrix XM based on a plurality of scale factors $(\alpha)$. For example, the input vector scaler 650 may generate a plurality of scaled input vectors based on a plurality of input vectors. In this case, a plurality of scaled input vectors may respectively correspond to the plurality of input vectors $\vec{X_1}$ to $\vec{X_h}$. Hereinafter, the scaled input vectors corresponding to $\vec{X_1}$ to $\vec{X_h}$ will be referred to as $\vec{X'_1}$ to $\vec{X'_h}$, respectively. The specific configuration and operation method of the input vector scaler 650 will be described later with reference to FIGS. 7 and 8.

In some example embodiments, the first data type converter 660 may extract an exponent EXP from each of the scaled input vectors $\vec{X'_1}, ..., \vec{X'_h}$. For example, the first data type converter 660 may extract a first exponent EXP1 from the first scaled input vector $\vec{X'_1}$, and a second exponent EXP2 from the second scaled input vector $\vec{X'_2}$. The first data type converter 660 may provide the extracted exponents EXP to the second data type converter 680.

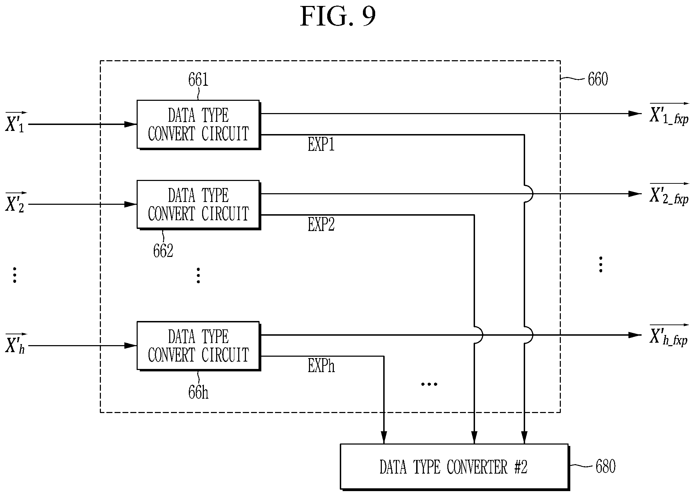

In some example embodiments, the first data type converter 660 may convert the data types of the plurality of scaled input vectors $\vec{X'_1}, ..., \vec{X'_h}$ into fixed-point. For example, the first data type converter 660 may receive the plurality of scaled input vectors $\vec{X'_1}, ..., \vec{X'_h}$, and output a plurality of fixed-point input vectors $\vec{X'_{1\_fxp}}, ..., \vec{X'_{h\_fxp}}$. The first data type converter 660 may convert the data types of the scaled input elements included in the plurality of scaled input vectors $\vec{X'_1}, ..., \vec{X'_h}$ into fixed-point based on the extracted exponent EXP. The specific configuration and operation method of the first data type converter 660 will be described later with reference to FIGS. 9 to 11.

In some example embodiments, the multiplication and accumulation operator array 670 may receive the first input matrix XM from the first input matrix buffer 610 and the second input matrix YM from the input parser 640. The multiplication and accumulation operator array 670 may further receive the control signal SEL from the input parser 640. The multiplication and accumulation operation array 670 may perform matrix multiplication on the first input matrix XM and the second input matrix YM based on the control signal SEL of the second level and output the first output matrix ZM. In various example embodiments, the multiplication and accumulation operator array 670 may perform multiplication and accumulation operations on the input elements of the first input matrix XM and the input elements of the second input matrix YM, and generate output elements of the first output matrix ZM.

In some example embodiments, the multiplication and accumulation operation array 670 may receive the plurality of fixed-point input vectors $\vec{X'_{1\_fxp}}, ..., \vec{X'_{h\_fxp}}$ from the first data type converter 660, and receive a binary vector $\vec{B}$ including the plurality of binary values b from the input parser 640. The multiplication and accumulation operator array 670 may receive the control signal SEL of the first level from the input parser 640. The multiplication and accumulation array 670 may perform multiplication operations on the fixed-point input vectors $\vec{X'_{1\_fxp}}, ..., \vec{X'_{h\_fxp}}$ and binary values b by accumulating the elements of the fixed-point input vectors $\vec{X'_{1\_fxp}}, ..., \vec{X'_{h\_fxp}}$ based on the plurality of binary values b, and generate fixed-point output vectors $\vec{P_{1\_fxp}}, \vec{P_{2\_fxp}}, \vec{P_{3\_fxp}}, ..., \vec{P_{nfxp}}$.

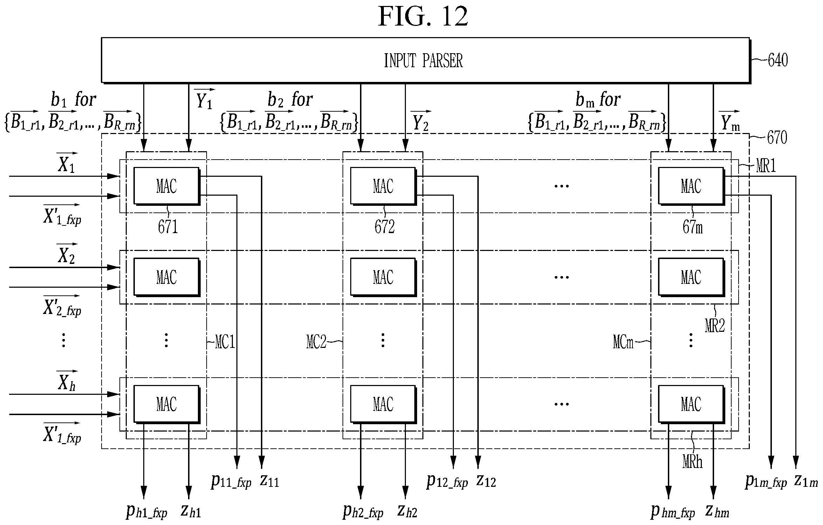

The detailed configuration and operation method of the multiplication and accumulation operator array 670 will be described later with reference to FIGS. 12 to 16.

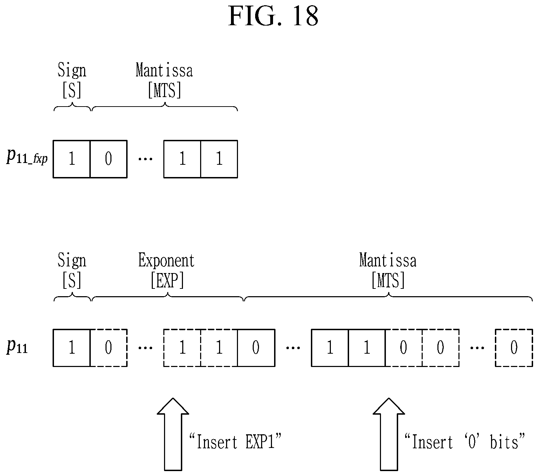

In some example embodiments, the second data type converter 680 may receive the plurality of exponents EXP from the first data type converter 660. The second data type converter 680 may receive fixed-point output vectors $\vec{P_{1\_fxp}}, \vec{P_{2\_fxp}}, \vec{P_{3\_fxp}}, ..., \vec{Pn_{fxp}}$ from the multiplication and accumulation operator array 670. The second data type converter 680 may receive a plurality of first level control signals SEL, and convert the data type of the fixed-point output vectors $\vec{P_{1\_fxp}}, \vec{P_{2\_fxp}}, \vec{P_{3\_fxp}}, ..., \vec{P_{nfxp}}$ into floating point based on the exponent EXP. For example, the second data type converter 680 may generate second output vectors $\vec{P_1}, \vec{P_2}, \vec{P_3}, ..., \vec{P_n}$ including floating point output elements. In some example embodiments, the second data type converter 680 may receive the first output matrix ZM from the multiplication and accumulation operator array 670. The second data type converter 680 may receive the control signal SEL of the second level and output the first output matrix ZM as output data of the second data type converter 680. The specific configuration and operation method of the second data type converter 680 will be described later with reference to FIG. 18.

FIG. 7 is a block diagram of an input vector scaler according to some example embodiments. The input vector scaler 650 according to some example embodiments may perform a multiplication operation on the first input matrix XM and a plurality of scale factors $(\alpha)$. In some example embodiments, the input vector scaler 650 may include first to (h)th input vector scaling circuits 651 to 65h.

In some example embodiments, each of the first to (h)th input vector scaling circuits 651 to 65h may receive different input vectors. For example, the first to (h)th input vector scaling circuits 651 to 65h may respectively receive the first to (h)th input vectors (i.e., $\vec{X_1}$ to $\vec{X_h}$).

In some example embodiments, each of the first to (h)th input vector scaling circuits 651 to 65h may sequentially receive a plurality of input elements. For example, the first input vector scaling circuit 651 may sequentially receive $x_{11}$ to $x_{1n}$, and the hth input vector scaling circuit 65h may sequentially receive $x_{h1}$ to $x_{hn}$.

In some example embodiments, each of the first to (h)th input vector scaling circuits 651 to 65h may receive a plurality of scale factors $(\alpha)$ from the input parser 640. The input parser 640 may parse a plurality of scale factors $(\alpha)$ received from the outside and sequentially provide the plurality of scale factors $(\alpha)$ to the first to (h)th input vector scaling circuits 651 to 65h.

In some example embodiments, the plurality of scale factors $(\alpha)$ that each of the first to (h)th input vector scaling circuits 651 to 65h receive from the input parser 640 may be the same. For example, the plurality of scale factors $(\alpha)$ received by the first input vector scaling circuit 651 may be the same as the plurality of scale factors $(\alpha)$ received by the second input vector scaling circuit 652.

In some example embodiments, the order in which each of the first to (h)th input vector scaling circuits 651 to 65h receives the plurality of scale factors $(\alpha)$ may be the same. For example, the scale factor $(\alpha)$ initially received by the first input vector scaling circuit 651 may be the same as the scale factor $(\alpha)$ initially received by the second input vector scaling circuit 652. Similarly, the scale factor $(\alpha)$ that the first input vector scaling circuit 651 receives a second time may be the same as the scale factor $(\alpha)$ that the second input vector scaling circuit 652 receives a second time.

In some (first) example embodiments, each of the first to (h)th input vector scaling circuits 651 to 65h may perform multiplication operations on the input elements and a plurality of scale factors $(\alpha)$ based on the order in which the input elements and the plurality of scale factors $(\alpha)$ are received. Since the multiplication operation method of each of the first to (h)th input vector scaling circuits 651 to 65h is the same or similar to the operation method of the multiplication and accumulation operator described in FIG. 4, a detailed description of the operation method of the first to (h)th input vector scaling circuits 651 to 65h is omitted here.

In some example embodiments, the first to (h)th input vector scaling circuits 651 to 65h may each perform a multiplication operation on an input element and a plurality of scale factors $(\alpha)$, and each generate the first to (h)th scaled input vectors $\overrightarrow{X'_1}$ to $\overrightarrow{X'_h}$. For example, the first input vector scaling circuit 651 may generate $\overrightarrow{X'_1}$, and the second input vector scaling circuit 652 may generate $\overrightarrow{X'_2}$.

FIG. 8 illustrates the operation of an input vector scaling circuit of FIG. 7. Hereinafter, for a more concise description, the operation of the first input vector scaling circuit 651 will be representatively described. However, example embodiments are not limited thereto, and the second to (h)th input vector scaling circuits 652 to 65h may also operate in the same or similar manner.

In some example embodiments, the first input vector scaling circuit 651 may receive the first input vector $\overrightarrow{X_1}$. That is, the first input vector scaling circuit 651 may sequentially receive $x_{11}$ to $x_{1n}$.

In some example embodiments, the first input vector scaling circuit 651 may sequentially receive a plurality of scale factors $(\alpha)$. For example, the first input vector scaling circuit 651 may receive the scale factors $\alpha_{1\_r1}$ to $\alpha_{R\_r1}$ corresponding to the first row vector $\overrightarrow{w_{r1}}$ of the weight matrix WM, and then may receive the scale factors $\alpha_{1\_r2}$ to $\alpha_{R\_r2}$ corresponding to the second row vector $\overrightarrow{w_{r2}}$. In this way, the first input vector scaling circuit 651 may sequentially receive all of the plurality of scale factors $\alpha_{1\_r1}$ to $\alpha_{R\_rn}$ from the input parser 640.

In some example embodiments, the first input vector scaling circuit 651 may perform a multiplication operation on the input elements $x_{11}$ to $x_{1n}$ and a plurality of scale factors $(\alpha)$. In some example embodiments, the first input vector scaling circuit 651 may perform operations on sign data, exponent data, and mantissa data of the input elements $x_{11}$ to $x_{1n}$ and a plurality of scale factors $(\alpha)$, respectively.

In some example embodiments, the first input vector scaling circuit 651 may output the scaled elements as the first scaled input vector $\overrightarrow{X'_1}$ based on the multiplication operation on the input elements $x_{11}$ to $x_{1n}$ and the plurality of scale factors $(\alpha)$. For example, the first input vector scaling circuit 651 may sequentially multiply the received input elements and the plurality of scale factors $(\alpha)$ to operate the elements of the plurality of scaled input vectors. The first input vector scaling circuit 651 may multiply $x_{11}$ by the scale factors $\alpha_{1\_r1}$ to $\alpha_{R\_r1}$ corresponding to the first row vector $\overrightarrow{w_{r1}}$ of the weight matrix WM to sequentially operate a plurality of scaled input elements 651_1 and $x_{11} \times \alpha_{k\_r1}$ corresponding to $x_{11}$.

Thereafter, the first input vector scaling circuit 651 may multiply $x_{12}$ by the scale factors $\alpha_{1\_r2}$ to $\alpha_{R\_r2}$ corresponding to the second row vector $\overrightarrow{w_{r2}}$ of the weight matrix WM to sequentially operate a plurality of scaled input elements 651_2 and $x_{12} \times \alpha_{k\_r2}$ corresponding to $x_{12}$. In this way, the first input vector scaling circuit 651 may sequentially operate up to a plurality of scaled input elements 651_3 and $x_{1n} \times \alpha_{k\_rn}$ corresponding to $x_{1n}$. Hereinafter, a plurality of scaled input elements 651_1 corresponding to $x_{11}$ may be represented by $x'_{11}$. Similarly, a plurality of scaled input elements 651_2 corresponding to $x_{12}$ may be represented by $x'_{12}$, and a plurality of scaled input elements 651_3 corresponding to $x_{1n}$ may be represented by $x'_{1n}$.

In some example embodiments, the first input vector scaling circuit 651 may sequentially output a plurality of scaled input elements 651_1, 651_2, ..., 651_3.

FIG. 9 is a block diagram of a first data type converter according to some example embodiments. The first data type converter 660 according to some example embodiments may convert the data types of the plurality of scaled input

vectors $\overrightarrow{X'_1}$ to $\overrightarrow{X'_h}$ into fixed-point. In some example embodiments, the first data type converter 660 may include first to (h)th data type convert circuits 661 to 66h.

In some example embodiments, each of the first to (h)th data type convert circuits 661 to 66h may receive different input vectors. For example, the first to (h)th data type convert circuits 661 to 66h may respectively receive the first to (h)th scaled input vectors $\overrightarrow{X'_1}$ to $\overrightarrow{X'_h}$.

In some example embodiments, each of the first to (h)th data type convert circuits 661 to 66h may extract an exponent from a plurality of input elements included in the scaled input vector. For example, the first data type convert circuit 661 may extract the first exponent EXP1 from the input elements (i.e., $x'_{11}$ to $x'_{1n}$) included in the first scaled input vector, and the second data type convert circuit 662 may extract the second exponent EXP2 from the input elements (i.e., $x'_{21}$ to $x'_{2n}$) included in the second input vector. In this way, the first to (h)th data type convert circuits 661 to 66h may extract the first to (h)th exponents EXP1 to EXPph, respectively. Each of the first to (h)th data type convert circuits 661 to 66h may provide the extracted exponent to the second data type converter 680.

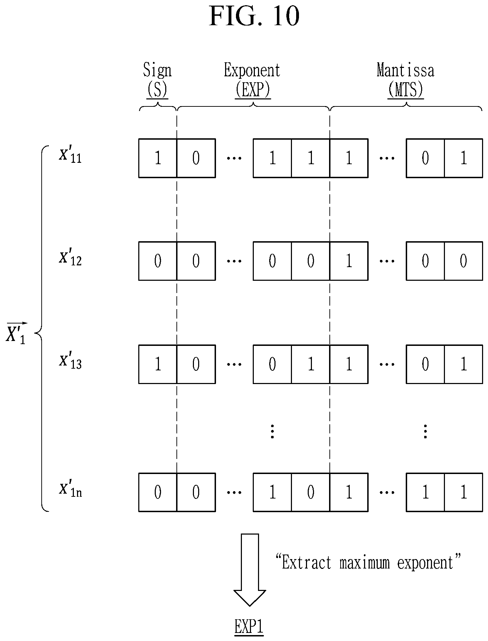

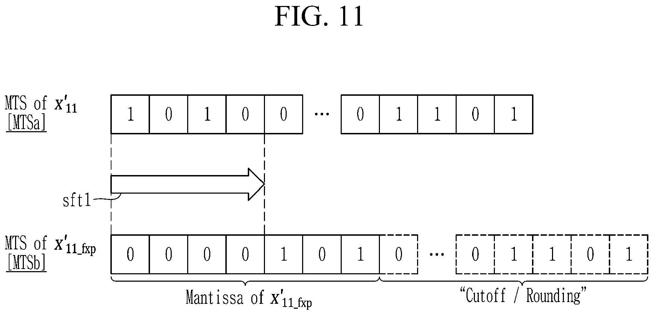

In some example embodiments, each of the first to (h)th data type convert circuits 661 to 66h may convert the data types of the scaled input vectors $\overrightarrow{X'_1}$ to $\overrightarrow{X'_h}$ into fixed-point based on the extracted exponents EXP1 to EXPh. The first to (h) th data type convert circuits 661 to 66h may output the first to (h)th fixed-point input vectors $\overrightarrow{X'_{1\_fxp}}$ to $\overrightarrow{X'_{h\_fxp}}$, respectively. For example, the first data type convert circuit 661 may convert each of the input elements $x'_{11}$ to $x'_{1''}$ included in the first scaled input vector $\overrightarrow{X'_1}$ into fixed-point format based on the first exponent EXP1. Detailed operations of the first to (h)th data type convert circuits 661 to 66h will be described later with reference to FIGS. 10 and 11 below.

FIG. 10 illustrates a method for extracting an exponent by the first data type converter of FIG. 9. Hereinafter, for a more concise explanation, the operation of the first data type convert circuit 661 to extract an exponent will be representatively described. However, example embodiments are not limited thereto.

Referring to FIG. 10, the first data type convert circuit 661 may receive a plurality of scaled input elements. For example, the first data type convert circuit 661 may receive $x'_{11}$ to $x'_{1n}$.

In some example embodiments, the data type of each of the plurality of input elements may be floating point. For example, $x'_{11}$ to $x'_{1n}$ may each include sign data S, exponent data EXP, and mantissa data MTS.

In some example embodiments, the first data type convert circuit 661 may determine the largest value among the values of the exponent EXP of each of the plurality of received input elements. In this case, the first data type convert circuit 661 may determine the exponent of the determined input element as the first exponent EXP1. That is, the first data type convert circuit 661 may extract the largest exponent among the exponents $x'_{11}$ to $x'_{1n}$.

For a more concise description, some example embodiments in which the first data type convert circuit 661 extracts the largest value among the exponent values of a plurality of input elements is representatively described in FIG. 10, but example embodiments are not limited thereto. For example, the first data type convert circuit 661 may be implemented to extract the smallest value among the values of the exponent of a plurality of input elements.

FIG. 11 illustrates an operation method of converting the data type of a received input vector into a fixed-point based on the exponent extracted by the first data type converter of FIG. 10. Hereinafter, for a more concise description, the operation of the first data type convert circuit 661 to extract an exponent will be representatively described. However, example embodiments are not limited thereto.

Referring to FIG. 11, the first data type convert circuit 661 may receive a plurality of input elements. For example, the first data type convert circuit 661 may receive $x'_{11}$ to $x'_{1n}$.

In some example embodiments, the first data type convert circuit 661 may extract the first exponent EXP1. The first data type convert circuit 661 may convert the data type of each scaled input element to a fixed-point based on the first exponent EXP1. For example, the first data type convert circuit 661 may convert $x'_{11}$ to $x'_{1n}$ into $x'_{11\_fxp}$ to $x'_{1n\_fxp}$, respectively. However, hereinafter, for a more concise description, the operation of the first data type convert circuit 661 that converts the input element "$x'_{11}$" into the fixed-point input element "$x'_{11\_fxp}$" will be representatively described.

In some example embodiments, the first data type convert circuit 661 may shift sft1 the mantissa (hereinafter referred to as a "first mantissa MTSa") of the scaled input element "$x'_{11}$" in the least significant bit (LSB) direction by the difference between the first exponent EXP1 and the exponent of $x'_{11}$. For example, when the difference between the values of the first exponent EXP1 and the exponent EXP of $x'_{11}$ is '4', the first data type convert circuit 661 may insert '4' '0' bits into a most significant bit (MSB) place of the first mantissa MTSa.

In some example embodiments, the first data type convert circuit 661 may determine the mantissa of the fixed-point input element "$x'_{11\_fxp}$" (hereinafter referred to as a "second mantissa MTSb") based on the shifted first mantissa MTSa. For example, the first data type convert circuit 661 may cut-off the lower-order bits of the shifted first mantissa MTSa according to the number of bits of the second mantissa MTSb. Alternatively, the first data type convert circuit 661 may determine the lower-order bits of the shifted first mantissa MTSPa based on various types of rounding algorithms such as "nearest even rounding," depending on the number of bits of the second exponent MTSb. However, example embodiments are not limited thereto.

In some example embodiments, the number of bits of the first mantissa MTSa may be '23-bit'. However, example embodiments are not limited thereto.

In some example embodiments, the number of bits of the second mantissa MTSb may be '7-bit'. However, example embodiments are not limited thereto.

In some example embodiments, each of the plurality of fixed-point input elements may be an integer. For example, the data type of each of the plurality of fixed-point input elements may be INT8 (8-bit integer). However, example embodiments are not limited thereto.

FIG. 12 is a block diagram of a multiplication and accumulation operator array according to some example embodiments. In some example embodiments, the multiplication and accumulation operator array 670 may include a plurality of multiplication and accumulation operators MACs arranged in row and column directions. Hereinafter, for a more concise description, it is assumed that a plurality of multiplication and accumulation operators MACs are arranged along (h) rows and (m) columns.

In some example embodiments, the multiplication and accumulation operator array 670 may include first to (h)th multiplication and accumulation operator rows MR1 to MRh. Each of the first to (h)th multiplication and accumulation operator rows MR1 to MRh may include a plurality of multiplication and accumulation operators MAC. For example, the first multiplication and accumulation operator row MR1 may include a plurality of multiplication and accumulation operators 671 to 67m. In some example embodiments, each of the first to (h)th multiplication and accumulation processors MR1 to MRh may receive input vectors $\overrightarrow{X_1}$ to $\overrightarrow{X_h}$ of the first input matrix XM and fixed-point input vectors $\overrightarrow{X'_{1\_fxp}}$, ..., $\overrightarrow{X'_{h\_fxp}}$ of the fixed-point input matrix XM'$_{\_fxp}$.

In some example embodiments, different multiplication and accumulation operator rows may receive different input vectors $\overrightarrow{X_1}$ to $\overrightarrow{X_h}$ and different fixed-point input vectors $\overrightarrow{X'_{1\_fxp}}$, ..., $\overrightarrow{X'_{h\_fxp}}$. In some example embodiments, the multiplication and accumulation operators included in the same multiplication and accumulation operator rows may receive the same input vectors $\overrightarrow{X_1}$ to $\overrightarrow{X_h}$ and the same fixed-point input vectors $\overrightarrow{X'_{1\_fxp}}$, ..., $\overrightarrow{X'_{h\_fxp}}$. For example, each of the multiplication and accumulation operators 671 to 67m included in the first multiplication and accumulation operator row MR1 may receive the first input vector $\overrightarrow{X_1}$ and the first fixed-point input vector $\overrightarrow{X'_{1\_fxp}}$.

In some example embodiments, the multiplication and accumulation operator array 670 may include first to (m)th multiplication and accumulation operator columns MC1 to MCm. Each of the first to (m)th multiplication and accumulation operator columns MC1 to MCm may include the plurality of multiplication and accumulation operators MAC. In some example embodiments, each of the first to (m)th multiplication and accumulation operator columns MC1 to MCm may receive the input vectors $\overrightarrow{Y_1}$ to $\overrightarrow{Y_m}$ of the second input matrix YM and the binary value b of and the binary vector $\overrightarrow{B}$. In some example embodiments, different multiplication and accumulation operator columns may receive different input vectors $\overrightarrow{Y_1}$ to $\overrightarrow{Y_m}$ and different binary values $b_1, b_2, ..., b_m$ of the binary vector $\overrightarrow{B}$. In some example embodiments, the multiplication and accumulation operators MAC included in the same multiplication and accumulation operator columns may receive the same input vectors $\overrightarrow{Y_1}$ to $\overrightarrow{Y_m}$ and the same binary values $b_1, b_2, ..., b_m$ of the binary vector $\overrightarrow{B}$. For example, the multiplication and accumulation operators MAC included in the first multiplication and accumulation operator column MC1 may receive the first input vector $\overrightarrow{Y_1}$ and the first binary value $b_1$ of the binary vector $\overrightarrow{B}$.

In some example embodiments, each of the multiplication and accumulation operators MAC may perform multiplication and accumulation operations on input elements. For example, the multiplication and accumulation operator 671 may perform multiplication and accumulation operations on the elements of the first input vector $\overrightarrow{X_1}$ of the first input matrix XM and the elements of the first input vector $\overrightarrow{Y_1}$ of the second input matrix YM, and output the first element $z_{11}$ of the first output matrix ZM.

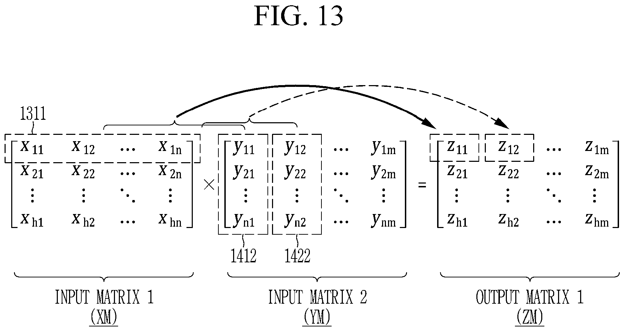

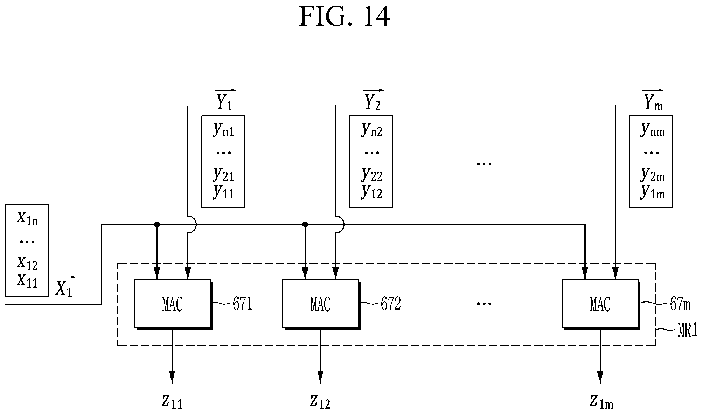

The specific operation method of these multiplication and accumulation operators will be described with reference to FIGS. 13 and 14.

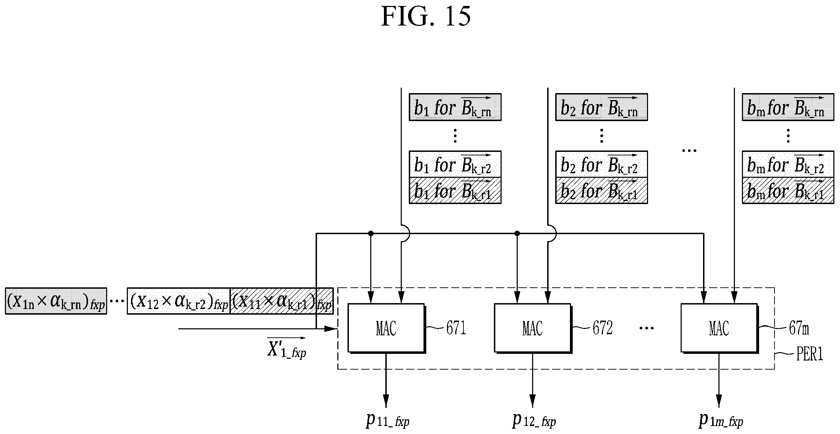

In some example embodiments, each of the multiplication and accumulation operators MAC may perform multiplication operations on fixed-point input elements and binary values. For example, the multiplication and accumulation operator 671 may perform multiplication operations on the fixed-point input elements and binary values based on the first binary value $b_1$ of binary vectors $\overrightarrow{B_{1\_r1}}$, $\overrightarrow{B_{2\_r1}}$, ..., $\overrightarrow{B_{R\_rn}}$ by accumulating the input elements of the fixed-point input vector $\overrightarrow{X'_{1\_fxp}}$, and output a first fixed-point output element $p_{11\_fxp}$. The specific operation method of these multiplication and accumulation operators will be described with reference to FIGS. 15 to 17.

FIGS. 13 and 14 illustrates an operation method of a multiplication and accumulation operator according to some example embodiments. Specifically, the multiplication and accumulation operator may perform multiplication and accumulation operations on the first input matrix XM and the second input matrix YM, and output the first output matrix ZM.

In some example embodiments, the multiplication and accumulation operator may perform multiplication and accumulation operations on the input elements included in a first row 1311 of the first input matrix XM and the input elements included in a first column 1412 of the second input matrix YM to operate the first output element $z_{11}$ included in the first output matrix ZM.

In addition, the multiplication and accumulation operator may perform multiplication and accumulation operations on the input elements included in the first row 1311 of the first input matrix XM and the input elements included in a second column 1422 of the second input matrix YM to operate a second output element $z_{12}$ included in the first output matrix ZM.

Referring to FIG. 14 together, in some example embodiments, each of the plurality of multiplication and accumulation operators 671, 672, ..., 67m included in the first multiplication and accumulation operator row MR1 may receive the first input vector $\overrightarrow{X_1}$ of the first input matrix XM. For example, each of the plurality of multiplication and accumulation operators 671, 672, ..., 67m may sequentially receive elements $x_{11}$ to $x_{1n}$ of the first input vector $\overrightarrow{X_1}$.

In some example embodiments, each of the plurality of multiplication and accumulation operators 671, 672, ..., 67m included in the first multiplication and accumulation operator row MR1 may receive different input vectors $\overrightarrow{Y_1}$ to $\overrightarrow{Y_m}$ of the second input matrix YM. For example, the first multiplication and accumulation operator 671 may sequentially receive a plurality of input elements $y_{11}$ to $y_{n1}$ included in the first input vector $\overrightarrow{Y_1}$ of the second input matrix YM, and the second multiplication and accumulation operator 672 may sequentially receive a plurality of input elements $y_{12}$ to $y_{n2}$ included in the second input vector $\overrightarrow{Y_2}$ of the second input matrix YM.

In some example embodiments, each of the multiplication and accumulation operators may perform multiplication and accumulation operations on the input elements of the first input matrix XM and the input elements of the second input matrix YM, based on the order in which they are received. For example, a first floating point multiplication circuit 671 may operate the first output element $z_{11}$ according to Equation 8 below.

(Equation 8)

$$z_{11} = x_{11} \times y_{11} + x_{12} \times y_{21} + \cdots + x_{1n} \times y_{n1}$$

The operation method of the multiplication and accumulation operator on the input elements of the first input matrix XM and the input elements of the second input matrix YM is similar to the operation method of the multiplication and accumulation operator in FIG. 4, so a detailed description thereof is omitted here.

FIG. 15 illustrates an operation method of a multiplication and accumulation operator according to some example embodiments. Specifically, FIG. 15 illustrates an operation method of the multiplication and accumulation operators on a fixed-point input matrix XM'$_{\text{fxp}}$ and a binary value b. Hereinafter, for a more concise description, the operation of the first multiplication and accumulation operator 671 that operates the first output element $p_{11\_\text{fxp}}$ of the fixed-point output matrix PM$_{\_\text{fxp}}$ will be representatively described. However, example embodiments are not limited thereto.

As described above with reference to FIG. 2, the weight matrix WM may include the plurality of row vectors $\overrightarrow{w_{r1}}$, ..., $\overrightarrow{w_{rm}}$, and by the quantization operation on the weight matrix WM, each of the row vectors may be represented by the sum of the products of a plurality of scale factors ($\alpha$) and the corresponding binary vector $\overrightarrow{B}$. Additionally, the binary vector $\overrightarrow{B}$ may be implemented as a row vector with the same dimension as the number of columns of the weight matrix WM (see Equation 6).

In some example embodiments, the first multiplication and accumulation operator 671 may receive the first fixed-point input vector $\overrightarrow{X'_{1\_\text{fxp}}}$ and the first binary value $b_1$ of the binary vectors $\overrightarrow{B_{1\_r1}}, \overrightarrow{B_{2\_r1}}, ..., \overrightarrow{B_{R\_rn}}$. The first multiplication and accumulation operator 671 may operate the first output element $p_{11\_\text{fxp}}$ of the fixed-point output matrix PM$_{\_\text{fxp}}$ based on the first fixed-point input vector $\overrightarrow{X'_{1\_\text{fxp}}}$ and the first binary value $b_1$ of the binary vectors $\overrightarrow{B_{1\_r1}}, \overrightarrow{B_{2\_r1}}, ..., \overrightarrow{B_{R\_rn}}$. Specifically, the first multiplication and accumulation operator 671 may operate the first output element $p_{11\_\text{fxp}}$ according to Equation 9 below.

(Equation 9)

$$p_{11\_\text{fxp}} \approx \left( (x_{11} \times \alpha_{1\_r1})_{\text{fxp}} \times b_{1\_1\_r1} + (x_{11} \times \alpha_{2\_r1})_{\text{fxp}} \times b_{1\_2\_r1} + \ldots + (x_{11} \times \alpha_{R\_r1})_{\text{fxp}} \times b_{1\_R\_r1} \right) +$$

$$\left( (x_{12} \times \alpha_{1\_r2})_{\text{fxp}} \times b_{1\_1\_r2} + (x_{12} \times \alpha_{2\_r2})_{\text{fxp}} \times b_{1\_2\_r2} + \ldots + (x_{12} \times \alpha_{R\_r2})_{\text{fxp}} \times b_{1\_R\_r2} \right) + \ldots + \left( (x_{1n} \times \alpha_{1\_rn})_{\text{fxp}} \times b_{1\_1\_rn} + (x_{1n} \times \alpha_{2\_rn})_{\text{fxp}} \times b_{1\_2\_rn} + \ldots + (x_{1n} \times \alpha_{R\_rn})_{\text{fxp}} \times b_{1\_R\_rn} \right)$$

In some example embodiments, the multiplication and accumulation operators MAC may output output elements $_{\overline{\text{fxp}}}$ by accumulating the elements of the fixed-point input vectors $\overrightarrow{X'_{1\_\text{fxp}}}, ..., \overrightarrow{X'_{h\text{fxp}}}$ based on the binary value b of the binary

vectors $\overrightarrow{B_{1\_r1}}, \overrightarrow{B_{2\_r1}}, \ldots, \overrightarrow{B_{R\_rn}}$. For example, the first multiplication and accumulation operator 671 may be configured to operate the first output element $p_{11\_fxp}$ by accumulating the elements of the first fixed-point input vector $\overrightarrow{X'_{1\_fxp}}$ based on the first binary value $b_1$ of the binary vectors $\overrightarrow{B_{1\_r1}}, \overrightarrow{B_{2\_r1}}, \ldots, \overrightarrow{B_{R\_rn}}$.

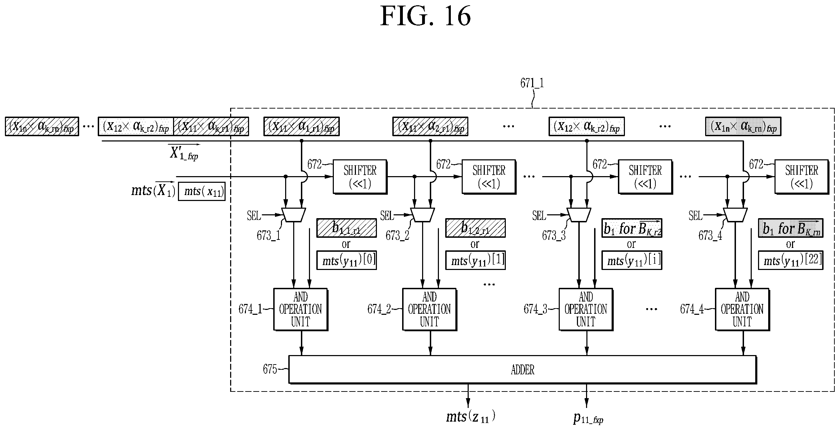

In some example embodiments, the fixed-point input vectors $\overrightarrow{X'_{1\_fxp}}, \ldots, \overrightarrow{X'_{h\_fxp}}$ and the binary values b of the binary vectors $\overrightarrow{B_{1\_r1}}, \overrightarrow{B_{2\_r1}}, \ldots, \overrightarrow{B_{R\_rn}}$ may be input into the mantissa operation units in the multiplication and accumulation operators MAC. A detailed description thereof will be provided later with reference to FIG. 16.

FIG. 16 is a block diagram of a mantissa operation unit of a multiplication and accumulation operator according to some example embodiments. As described above with reference to FIGS. 4 and 5, the multiplication and accumulation operators may include a sign operation unit, an exponent operation unit, and a mantissa operation unit. The mantissa operation unit of the multiplication and accumulation operator according to some example embodiments may perform multiplication and accumulation operations on the mantissa data of the input elements of the first input matrix XM and the second input matrix YM, or may perform a multiplication operation on the first fixed-point input vector $\overrightarrow{X'_{1\_fxp}}$ and the binary value b. Hereinafter, for a more concise description, the operation of a mantissa operator 671_1 of the first multiplication and accumulation operator 671 will be representatively described. However, example embodiments are not limited thereto, and mantissa operation units of other multiplication and accumulation operators may also operate in the same or similar manner.

In some example embodiments, the first multiplication and accumulation operator 671 may receive the first fixed-point input vector $\overrightarrow{X'_{1\_fxp}}$ and the first binary value $b_1$ of the binary vectors $\overrightarrow{B_{1\_r1}}, \overrightarrow{B_{2\_r1}}, \ldots, \overrightarrow{B_{R\_rn}}$. Specifically, the first multiplication and accumulation operator 671 may receive the first fixed-point input vector $\overrightarrow{X'_{1\_fxp}}$ from the first data type converter 660, and may receive the first binary value b1 of the binary vectors $\overrightarrow{B_{1\_r1}}, \overrightarrow{B_{2\_r1}}, \ldots, \overrightarrow{B_{R\_rn}}$ from the input parser 640. The first fixed-point input vector $\overrightarrow{X'_{1\_fxp}}$ and the first binary value b1 of the binary vectors $\overrightarrow{B_{1\_r1}}, \overrightarrow{B_{2\_r1}}, \ldots, \overrightarrow{B_{R\_rn}}$ may input to the mantissa operation unit 671_1 of the first multiplication and accumulation operator 671.

In some example embodiments, the mantissa operation unit 671_1 may include the shifter 672, a multiplexer 673, an AND operator 674, and an adder 675.

In some example embodiments, the multiplexer 673 may receive mantissa data mts $(x_{11})$ of the first input element and input elements of the first fixed-point input vector $\overrightarrow{X'_{1\_fxp}}$. The multiplexer 673 may receive the mantissa data mts $(x_{11})$ of the first input element from the first input matrix buffer 610, and may receive the input elements of the first fixed-point input vector $\overrightarrow{X'_{1\_fxp}}$ from the first data type converter 660.

The multiplexer 673 may output the input element of the first fixed-point input vector $\overrightarrow{X'_{1\_fxp}}$ as output data based on the control signal SEL (e.g., first level) of the input parser 640. For example, the first multiplexer 673_1 may receive the mantissa data mts $(x_{11})$ of the first input element and the input element $(x_{11} \times \alpha_{1\_r1})_{fxp}$ of the first fixed-point input vector $\overrightarrow{X'_{1\_fxp}}$, and may output $(x_{11} \times \alpha_{1\_r1})_{fxp}$ as output data based on the control signal SEL of the first level.

In some example embodiments, a first AND operation unit 674_1 may receive the output data $(x_{11} \times \alpha_{1r1})_{fxp}$ of the first multiplexer 673_1 and the first binary value $b_{1\_1\_r1}$ of the first binary vector $\overrightarrow{B_{1\_r1}}$.

The first AND operation unit 674_1 may receive output data $(x_{11} \times \alpha_{1\_r1})_{fxp}$ from the first multiplexer 673_1, and may receive the first binary value $b_{1\_1\_r1}$ of the first binary vector $\overrightarrow{B_{1\_r1}}$ from the input parser 640. The first AND operation unit 674_1 may output the AND results of them. For example, if the first binary value $b_{1\_1\_r1}$ is '1', the first AND operation unit 674_1 may output the output data $(x_{11} \times \alpha_{1\_r1})_{fxp}$ of the first multiplexer 673_1 as is, and if the first binary value $b_{1\_1\_r1}$ is '0', data in which all bits are '0' may be output.

In some example embodiments, the shifter 672 may left-shift the mantissa data mts $(x_{11})$ of the first input element by 1-bit, and provide the shifted data as the input data of a second multiplexer 673_2.

In some example embodiments, the second multiplexer 673_2 may receive the mantissa data mts $(x_{11})$ of the shifted first input element and the input element $(x_{11} \times \alpha_{2\_r1})_{fxp}$ of the first fixed-point input vector $\overrightarrow{X'_{1\_fxp}}$, and output $(x_{11} \times \alpha_{2\_r1})_{fxp}$ as output data based on the control signal SEL of the first level. The second AND operator 674_2 may receive the output data $(x_{11} \times \alpha_{2\_r1})_{fxp}$ of the second multiplexer 673_2 and the first binary value $b_{1\_2\_r1}$ of the second binary vector $b_{1\_2\_r1}$, and output the AND results of them. In the above-described manner, the multiplexer 673 may output the input elements of the first fixed-point input vector $\overrightarrow{X'_{1\_fxp}}$, and the AND operation unit 674 may output the AND result on the input elements of the first fixed-point input vector $\overrightarrow{X'_{1\_fxp}}$ and the first binary value $b_1$ of the binary vectors $\overrightarrow{B_{1\_r1}}, \overrightarrow{B_{2\_r1}}, \ldots, \overrightarrow{B_{R\_rn}}$,

In some example embodiments, the adder 675 may receive the AND results of the AND operation units 674. The adder 675 may add the AND results of the AND operation units 674 and output the first fixed-point output element $p_{11\_fxp}$.

In some example embodiments, the first multiplexer 673_1 may receive mantissa data mts $(x_{11})$ of the first input element and input elements of the first fixed-point input vector $\overrightarrow{X'_{1\_fxp}}$. The multiplexer 673 may output the mantissa data mts $(x_{11})$ of the first input element as output data based on the control signal SEL of the second level. In some example embodiments, the AND operation unit 674 may receive the mantissa data mts $(x_{11})$ of the first input element from the first multiplexer 673_1, and receive the mantissa data mts $(y_{11})$ of the second input element from the input parser 640.

For example, the first AND operation unit 674_1 may receive the mantissa data mts $(x_{11})$ of the first input element and the lowermost bit mts$(y_{11})[0]$ of the mantissa data of the second input element as input data, and output the AND results of them as output data. In some example embodiments, the adder 675 may sum the AND results of the AND operation units 674 and output mantissa data $mts(z_{11})$ of the first output element.

As described above, the multiplication and accumulation operator according to some example embodiments may perform multiplication and accumulation operations on mantissa data of input elements, and/or may perform accumulation operations on input elements of a fixed-point input vector based on binary values. Here, it is assumed that the number of bits in the mantissa data $mts(y_{11})$ of the second input matrix YM, the number of the input elements of the first fixed-point input vector $\overrightarrow{X'_{1\_fxp}}$, and the number of the first binary values $b_1$ of the binary vectors $\overrightarrow{B_{1\_r1}}, \overrightarrow{B_{2\_r1}}, ..., \overrightarrow{B_{R\_rn}}$ are the same, but it is not limited thereto, and the number of elements in the input elements of the first fixed-point input vector $\overrightarrow{X'_{1\_fxp}}$ and the number of the first binary values $b_1$ of the binary vectors $\overrightarrow{B_{1\_r1}}, \overrightarrow{B_{2\_r1}}, ..., \overrightarrow{B_{R\_rn}}$ may be less than or greater than the number of bits in the mantissa data $mts(y_{11})$ of the input element of the second input matrix YM.

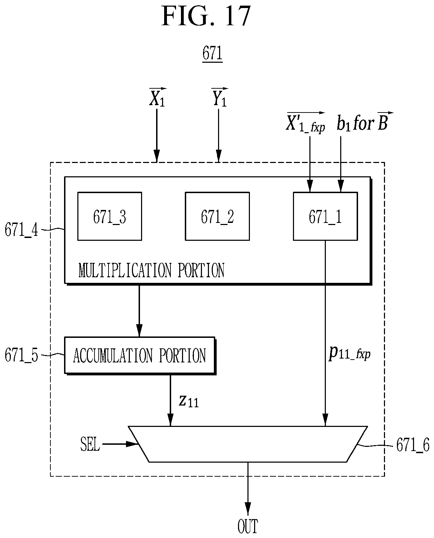

FIG. 17 is a block diagram of a multiplication and accumulation operator according to some example embodiments. Hereinafter, for a more concise description, the configuration and operation method of the first multiplication and accumulation operator 671 will be representatively described. However, example embodiments are not limited thereto, and other multiplication and accumulation operators may operate identically or similarly.

In some example embodiments, the multiplication and accumulation operator 671 may receive the first input vector $\overrightarrow{X_1}$ and the second input vector $\overrightarrow{Y_1}$. The data type of the first input vector $\overrightarrow{X_1}$ and the second input vector $\overrightarrow{Y_1}$ may be floating point data. The multiplication and accumulation operator 671 may perform a multiplication operation on the first input vector $\overrightarrow{X_1}$ and the second input vector $\overrightarrow{Y_1}$ and generate the first output element $z_{11}$.

In some example embodiments, the multiplication and accumulation operator 671 may receive a first fixed-point input vector $\overrightarrow{X'_{1\_fxp}}$ and the first binary value $b_1$ of the binary vector $\overrightarrow{B}$. The data type of the first fixed-point input vector $\overrightarrow{X'_{1\_fxp}}$ may be fixed-point data. The multiplication and accumulation operator 671 may perform multiplication operations on the first fixed-point input vector $\overrightarrow{X'_{1\_fxp}}$ and the first binary value $b_1$ of the binary vector $\overrightarrow{B}$, and may output the first fixed-point output element $p_{11\_fxp}$.

In some example embodiments, the multiplication and accumulation operator 671 may include a multiplication portion 671_4 and an accumulation portion 671_5. The multiplication portion 671_4 may include a sign operation unit 671_3, an exponent operation unit 671_2, and a mantissa operation unit 671_1.

In some example embodiments, the sign operation unit 671_3 may receive sign data of a plurality of elements of the first input vector $\overrightarrow{X_1}$ and sign data of a plurality of elements of the second input vector $\overrightarrow{Y_1}$, and generate sign data of the first output element $z_{11}$.

In some example embodiments, the exponent operation unit 671_2 may receive exponent data of a plurality of elements of the first input vector $\overrightarrow{X_1}$ and exponent data of a plurality of elements of the second input vector $\overrightarrow{Y_1}$, and generate sign data of the first output element $z_{11}$.

In some example embodiments, the mantissa operation unit 671_1 may receive mantissa data of a plurality of elements of the first input vector $\overrightarrow{X_1}$ and mantissa data of a plurality of elements of the second input vector $\overrightarrow{Y_1}$, and generate mantissa data of the first output element $z_{11}$. In addition, the sign operation unit 671_3 may perform multiplication operations on the first fixed-point input vector $\overrightarrow{X'_{1\_fxp}}$ and the first binary value $b_1$ of the binary vector $\overrightarrow{B}$, and output the first fixed-point output element $p_{11\_fxp}$.

In some example embodiments, the accumulation portion 671_5 may perform an accumulation operation by adding the data received from the multiplication portion 671_4, and output the first output element $z_{11}$.

In some example embodiments, the multiplication and accumulation operator 671 may further include a multiplexer 671_6. The multiplexer 671_6 may receive the first fixed-point output element $p_{11\_fxp}$ from the mantissa operation unit 671_3 and the first output element $z_{11}$ from the accumulation portion 671_5. The multiplexer 671_6 may output the first fixed-point output element $p_{11\_fxp}$ based on the control signal SEL of the first level, or the first output element $z_{11}$ based on the control signal SEL of the second level.

FIG. 18 illustrates the operation of a second data type converter according to some example embodiments. Hereinafter, for a more concise description, the operation of the second data type converter 680 for the first fixed-point output element $p_{11\_fxp}$ will be representatively described. However, example embodiments are not limited thereto. For example, the second data type converter 680 may operate in a similar manner for any fixed-point output element $p_{ij\_fxp}$.

Referring to FIG. 6 together, in some example embodiments, the second data type converter 680 may receive the first output matrix ZM and the fixed-point output vectors $\overrightarrow{P_{1\_fxp}}, \overrightarrow{P_{2\_fxp}}, ..., \overrightarrow{P_{n\_fxp}}$ from the multiplication and accumulation operator array 670. Based on the control signal SEL received from the input parser 640, the second data type converter 680 may output the first output matrix ZM as output data as is, or convert the data type of the fixed-point output vectors $\overrightarrow{P_{1\_fxp}}, \overrightarrow{P_{2\_fxp}}, ..., \overrightarrow{P_{n\_fxp}}$ into floating point and output the converted output vectors $\overrightarrow{P_1}, \overrightarrow{P_2}, ..., \overrightarrow{P_n}$ as output data. For example, when the control signal SEL of the second level is received from the input parser 640, the second data type converter 680 may output the received first output matrix ZM received from the multiplication and accumulation operator array 670 as the output data as is. Alternatively, when the control signal SEL of the first level is received from the input parser 640, the second data type converter 680 may convert the data type of the fixed-point output vectors $\overrightarrow{P_{1\_fxp}}, \overrightarrow{P_{2\_fxp}}, ..., \overrightarrow{P_{n\_fxp}}$ into floating point based on the exponent EXP received from the first data type converter 660, and output the converted output vectors $\overrightarrow{P_1}, \overrightarrow{P_2}, ..., \overrightarrow{P_n}$ as the output data.

Referring to FIG. 18, the first fixed-point output element $p_{11\_fxp}$ may include exponent data S and mantissa data MTS. The second data type converter 680 may convert the data type of the first fixed-point output element $p_{11\_fxp}$ into floating point and output the first output element $p_{11}$. Specifically, the second data type converter 680 may add exponent data EXP to the first fixed-point output element $p_{11\_fxp}$. For example, the second data type converter 680 may determine the exponent corresponding to the fixed-point output element $p_{11\_fxp}$ among the exponents EXP1, ..., EXPh received from the first data type converter 660 as the exponent EXP of the first output element $p_{11}$. More specifically, when the first fixed-point output element $p_{11\_fxp}$ is included in the first fixed-point output vector $\overrightarrow{P_{1\_fxp}}$, the exponent data EXP of the first fixed-point output element $p_{11\_fxp}$ may be determined as the first exponent data $\overline{EXP1}$.

In some example embodiments, the second data type converter 680 may add a plurality of '0' bits to the LSB digit of the mantissa data of the first output element $p_{11}$, based on a difference in the number of bits in the mantissa data of the first fixed-point output element $p_{11\_fxp}$ and in the mantissa data of the first output element $p_{11}$. However, example embodiments are not limited thereto.

The second data type converter 680 according to some example embodiments may convert the data type of the fixed-point output elements into floating point according to the method described above, and output the second output matrix PM including the output element as output data.

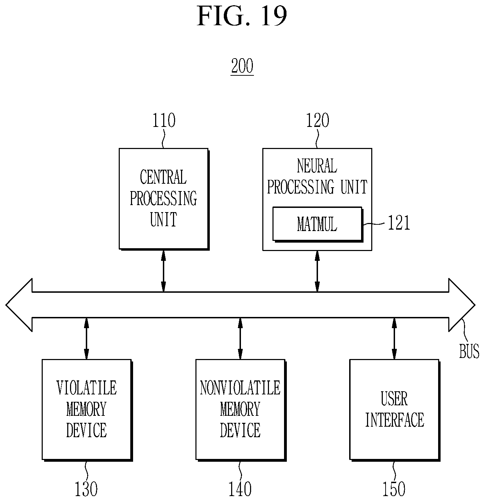

FIG. 19 is a block diagram showing a neural processing system according to some example embodiments. A neural processing system 200 may train (or learn) a neural network, or infer information included in the input data by analyzing the input data using the neural network. The neural processing system 200 may judge the situation based on the inferred information or control the configurations of the electronic device on which the neural processing system 200 is mounted. For example, the neural processing system 200 may be applied to or may include (or be included in) various electronic devices such as one or more of smartphones, tablet devices, smart TVs, augmented reality (AR) devices, internet of things (IoT) devices, autonomous vehicles, robotics, medical devices, drones, advanced driver assistance systems (ADAS), image display devices, measurement devices, etc., to perform tasks such as voice recognition, image recognition, and image classification using neural networks. Additionally, the neural processing system 200 may be mounted on one of various types of electronic devices.

Referring to FIG. 19, the neural processing system 200 may include a central processing unit 110, a neural processing unit 120, a volatile memory device 130, a non-volatile memory device 140, and a user interface 150. In some example embodiments, some or all of the components of the neural processing system 200 (e.g., the central processing unit 110, the neural processing unit 120, the volatile memory device 130, and the non-volatile memory device 140) may be formed on a single semiconductor chip. For example, the neural processing system 200 may be implemented as a system-on-chip (SoC); however, example embodiments are not limited thereto. The central processing unit 110, the neural processing unit 120, the volatile memory device 130, the non-volatile memory device 140, and the user interface 150 may be connected to each other through a bus.

The central processing unit 110 may control overall operations of the neural processing system 200. The central processing unit 110 may include one processor core (single core) or a plurality of processor cores (multi-core). The central processing unit 110 may process or execute programs and/or data stored in storage regions such as the volatile memory device 130 and the non-volatile memory device 140.

The central processing unit 110 may execute an application and control the neural processing unit 120 to perform neural network-based tasks required by the execution of the application. The neural network may include (or be included in) at least one of various types of neural network models, such as a convolution neural network (CNN), a region with CNN (R-CNN), a region proposal network (RPN), a recurrent neural network (RNN), a stacking-based deep neural network (S-DNN), a state-space dynamic neural network (S-SDNN), a deconvolution network, a deep belief network (DBN), a restricted Boltzmann machine (RBM), a fully convolutional network, a long short-term memory (LSTM) network, a classification network, and a transformer.

A neural network model may include a plurality of layers. Each of the plurality of layers may be implemented to receive input data of the layer and generate output data of the layer. At this time, the output data of the generated layer may be used as input data of another layer. Each of the plurality of layers may transform input data into output data through neural network operations. For example, each of the plurality of layers may generate an output matrix corresponding to the output data of the layer by dot-producting (taking the inner product of) a weight matrix to the input matrix corresponding to the input data of the layer. However, example embodiments are not limited thereto, and each of the plurality of layers may generate output data by converting the input matrix corresponding to the input data of the layer in an arbitrary manner. For example, each of the plurality of layers may be implemented by sequentially multiplying a plurality of weight matrices with the input matrix corresponding to the input data of the layer to generate the output data of the layer, or by transforming the input matrix based on transformation parameters to generate the output data of the layer.

The neural processing unit 120 may access the volatile memory device 130 to perform neural network operations. For example, the neural processing unit 120 may read parameters stored in the volatile memory device 130 to perform an operation on layer input data, or temporarily store intermediate data generated during the operation in the volatile memory device 130.

The neural processing unit 120 may access the non-volatile memory device 140 to perform neural network operations. For example, a neural processing unit 120 may read operation parameters (e.g., weight values, bias values) and input data (e.g., input feature maps) for a neural network stored in the non-volatile memory device 140, to perform neural network operations.

In some example embodiments, the neural processing unit 120 may include a matrix multiplier 121, MATMUL, for performing neural network operations. For example, the matrix multiplier 121 may perform a dot-product operation on the input matrix and weight matrix of each layer. The matrix multiplier 121 may perform a dot-product operation on the input matrix and weight matrix of each layer, or may include a multiplication and accumulation (MAC) operator for performing a dot-product operation on the input matrices. The matrix multiplier 121 may perform multiplication and accumulation operations on input data.

In some example embodiments, the volatile memory device 130 may be used as one or more of a buffer memory, operational memory, or cache memory of the central processing unit 110. The volatile memory may include one or more of dynamic RAM (DRAM), static RAM (SRAM), synchronous DRAM (SDRAM), phase-change RAM (PRAM), magnetic RAM (MRAM), resistive RAM (RRAM), and ferroelectric RAM (FeRAM). However, example embodiments are not limited thereto.

The non-volatile memory device 140 may store data for operation of the neural processing system 200. For example, the non-volatile memory device 140 may store the operating system (OS) of the neural processing system 200, the operation parameters for the neural network (e.g., weight values, bias values), parameters for quantization of the neural network (e.g., scale factor, bias values), input data (e.g., input feature map), and output data (e.g., output feature map). The operation parameters, quantization parameters, input data, and output data may be floating point data or integer data. The non-volatile memory device 140 may include one or more of read only memory (ROM), programmable ROM (PROM), electrically programmable ROM (EPROM), electrically erasable and programmable ROM (EEPROM), flash memory, phase-change RAM (PRAM), magnetic RAM (MRAM), resistive RAM (RRAM), ferroelectric RAM (FRAM), phase-change RAM (PRAM), magnetic RAM (MRAM), resistive RAM (RRAM), and ferroelectric RAM (FeRAM), and/or the like. However, example embodiments are not limited thereto.

The central processing unit 110 may communicate with a user through the user interface 150. The central processing unit 110 may provide input data provided by the user to the volatile memory device 130 or the neural processing unit 120 through the user interface 150. The central processing unit 110 may return output data generated by the artificial intelligence model based on input data to the user through the user interface 150.

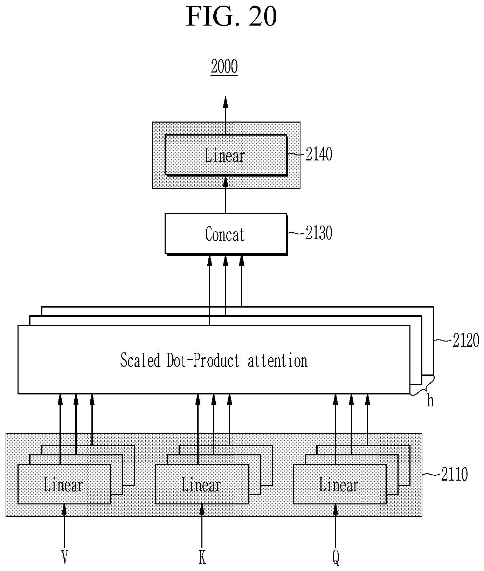

FIG. 20 illustrates an example of a multi-head attention according to some example embodiments.

A multi-head attention 2000 is a mechanism used in the transformer model and automatic speech recognition (ASR) model among neural network models, and has a shape in which a scaled dot-product attention 2120 structure is overlapped (h). In some example embodiments, the multi-head attention 2000 may perform self-attention regarding embedding of input data. Embedding may refer to the result or a series of processes of converting natural language used by humans into a vector form that machines may understand.

When processing sequence data such as natural language, long-term dependency may be an issue. Self-attention is intended to solve the long-term dependency, and by using self-attention, it is possible to measure the relationship between words in a sentence. Specifically, the relationship value with other words may be calculated based on each word, and this value is referred to as the attention score. The attention score between words with a high degree of relationship may be high. A table of attention scores is referred to as an attention map. The multi-head attention 2000 may create a plurality of attention maps to check attentions for various feature values.

In the multi-head attention 2000, the input to the scaled dot-product attention 2120 includes query Q, key K, and value V. For example, when looking up the meaning of a specific word through an English dictionary, the specific word may correspond to a query, a word registered in the dictionary may correspond to a key, and the meaning of the key may correspond to a value.

The multi-head attention 2000 may reduce the dimensions of the value V, key K, and query Q through a first linear operation layer 2110, perform self-attention through h scaled dot-product attentions 2120, and perform a linear operation through a concatenation 2130 and a second linear operation layer 2140 on the attention result.

In some example embodiments, the linear operation performed in the first linear operation layer 2110 and the second linear operation layer 2140 may refer to a matrix dot-product operation. For example, the first linear operation layer 2110 may perform dot-product operations by multiplying the embedding vector of the input data with specific weights to reduce the dimensions of the value V, key K, and query Q derived from the embedding information of the input data. The second linear operation layer 2140 may perform dot-product operations by multiplying specific weights to the chained output matrix.

The first linear operation layer 2110 and the second linear operation layer 2140 may use a matrix multiplier (100 in FIG. 1) according to some example embodiments to perform a matrix dot-product operation. The matrix multiplier 100 according to some example embodiments may receive an input matrix and a weight matrix input to the first linear operation layer 2110 and the second linear operation layer 2140 as input data, and perform a matrix dot-product operation on them.

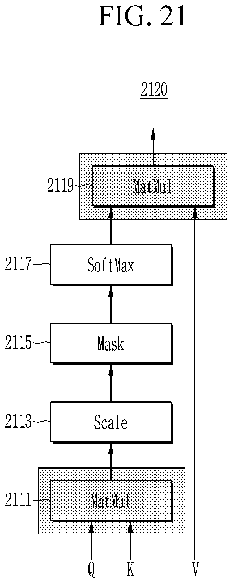

FIG. 21 illustrates an example of a scaled dot-product attention of FIG. 20.

A matrix multiplication layer 2111 of the scale dot-product attention 2120 may perform the dot-product operation of the key K and the query Q, and output an attention score indicating similarity. A scaling layer 2113 may perform scaling to adjust the size of the attention score output from the first matrix multiplication layer 2111. A mask layer 2125 may prevent attention to incorrect connections through masking. A softmax operation layer 2127 may calculate the weight based on the attention score. A second matrix multiplication layer 2129 may perform a dot-product operation on the weight and the value V, which are the outputs of the softmax operation layer 2127.

The first matrix multiplication layer 2111 and the second matrix multiplication layer 2129 may use the matrix multiplier 100 according to some example embodiments. For example, the first matrix multiplication layer 2111 may receive a key K vector and a query Q vector as input data, and the second matrix multiplication layer 2127 may receive a value V vector and weight matrix as input data. In some example embodiments, the input data vectors of the first matrix multiplication layer 2111 and the second matrix multiplication layer 2127 may be floating point data. The matrix multiplier 100 according to some example embodiments may perform a matrix dot-product operation on the key K vector and the query Q vector, which are input data of the first matrix multiplication layer 2111, and perform a matrix dot-product operation on the value V vector and weight matrix, which are the input data of the second matrix multiplication layer 2127.

Any of the elements and/or functional blocks disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc. The processing circuitry may include electrical components such as logic gates including at least one of AND gates, OR gates, NAND gates, NOT gates, etc.

While various example embodiments have been described in detail, it is to be understood that inventive concepts are not limited to variously described example embodiments, but on the contrary, is intended to cover various modifications and equivalent arrangements included within the scope of the appended claims. Furthermore, example embodiments are not necessarily mutually exclusive with one another. For example, some example embodiments may include one or more features described with reference to one or more figures, and may also include one or more other features described with reference to one or more other figures.

Embodiments of the invention are set out in the following numbered clauses.

1. A matrix multiplier, comprising:

an input vector scaler configured to generate a scaled input matrix based on a first input matrix and on a plurality of scale factors;
a first data type converter configured to convert the data type of the scaled input matrix to fixed-point and to generate a fixed-point input matrix;
a multiplication and accumulation operator array configured to receive the fixed-point input matrix and a plurality of binary vectors, to generate a fixed-point output matrix based on the fixed-point input matrix and on the plurality of binary vectors, to generate the first input matrix and a second input matrix, and to generate a first output matrix based on the first input matrix and the second input matrix; and
a second data type converter configured to convert the data type of the fixed-point output matrix to a floating point and to generate a second output matrix.

2. The matrix multiplier of clause 1, further comprising:
an input parser configured to receive the second input matrix, the plurality of scale factors and the plurality of binary vectors as weight matrix from outside, to sequentially provide the plurality of scale factors to the input vector scaler, to sequentially provide the second input matrix and the plurality of binary vectors to the multiplication and accumulation operator array, and to provide a first signal that control the multiplication and accumulation operator array and the second data type converter.

3. The matrix multiplier of clause 2, wherein

the multiplication and accumulation operator array comprises
a first multiplication and accumulation operator configured to receive a first input vector of the first input matrix and a first input vector of the second input matrix, and to receive a first fixed-point input vector of the fixed-point input matrix and a first binary value of the plurality of binary vectors.

4. The matrix multiplier of clause 3, wherein

the first multiplication and accumulation operator is configured to:
perform a multiplication operation on the first binary value of the plurality of binary vectors and on the first fixed-point input vector and generate a first fixed-point output element of the fixed-point output matrix, the multiplication operation on the first binary value and the generating a first fix-point output element based on the first signal having a first level,
and perform a multiplication operation on the first input vector of the first input matrix and the first input vector of the second input matrix and generate a first output element of the first output matrix, the multiplication operation on the first input vector and the generating the first output element based on the first signal having a second level different from the first level.

5. The matrix multiplier of clause 4, wherein
the first multiplication and accumulation operator comprises:

a first circuit configured to output sign data of the first output element;
a second circuit configured to output exponent data of the first output element; and
a third circuit configured to generate the first fixed-point output element based on the first signal having the first level, and output mantissa data of the first output element based on the first signal having the second level.

6. The matrix multiplier of clause 5, wherein the third circuit comprises:

a first multiplexer configured to receive mantissa data of a first input element of the first input vector and mantissa data a first fixed-point input element, and to output the first fixed-point input element based on the first signal;
a first AND operation unit configured to perform an AND operation on the first binary values of the plurality of binary vectors and the first fixed-point input element; and
an addition unit configured to add the output data of the first AND operation unit.

7. The matrix multiplier of clause 5 or clause 6, wherein

the first multiplication and accumulation operator further comprises
a multiplexer configured to receive the first output element and the first fixed-point output element, and to output the first fixed-point output element as output data of the first multiplication and accumulation operator based on the first signal.

8. The matrix multiplier of any of clauses 3 to 7, wherein
the multiplication and accumulation operator array further comprises:

a second multiplication and accumulation operator configured to receive the first input vector of the first input matrix, a second input vector of the second input matrix, the first fixed-point input vector, and a second binary value of the plurality of binary vectors; and
a third multiplication and accumulation operator configured to receive the second input vector of the first input matrix, the first input vector of the second input matrix, the second fixed-point input vector of the fixed-point input matrix, and the first binary value of the plurality of binary vectors.

9. The matrix multiplier of any of clauses 2 to 8, wherein

the first data type converter comprises
a first data type convert circuit configured to receive a first plurality of scaled input vectors of the scaled input matrix, to extract a largest first exponent among the exponents of each of a first plurality of scaled input elements included in the first plurality of scaled input vectors, and to convert the data type of each of the first plurality of scaled input elements into a fixed-point based on the first exponent.

10. The matrix multiplier of clause 9, wherein
the second data type converter configured to:
receive a first fixed-point output vector of the fixed-point output matrix and the first signal, and convert the data type of each of a first plurality of fixed-point output elements included in the first fixed-point output vector to a floating point based on the first exponent.

11. The matrix multiplier of clause 10, wherein

the second data type converter is configured to receive the first output matrix,
and to output the first output matrix based on the first signal having a second level.

12. A multiply-and-accumulate (MAC) operator, comprising:

a first multiplexer configured to receive mantissa data of a first data of a first data type and mantissa data of a second data of a second data type different from the first data type, output the first data based on a first signal, and output the mantissa data of the second data based on a second signal different from the first data;
a first AND operation unit configured to receive a plurality of binary values and perform an AND operation of a first binary value among the plurality of binary values and the first data; and
an adder configured to add output data of the first AND operation unit and to output a first output data of the first data type.

13. The MAC operator of clause 12, wherein

the first AND operation unit is configured to further receive mantissa data of third data of the second data type, and to perform an AND operation of a first bit value of the mantissa data of the third data and the mantissa data of the second data,
and the adder is configured to output mantissa data of a second output data of the second data type.

14. The MAC operator of clause 13, further comprising:

a first shifter configured to shift the mantissa data of the second data by 1 bit;
a second multiplexer configured to receive a fourth data of the first data type and mantissa data of the shifted second data, to output the fourth data based on the first signal, and to output mantissa data of the shifted second data based on the second signal; and
a second AND operation unit configured to perform an AND operation of a second binary value among the plurality of binary values and the fourth data, and to perform an AND operation of a second bit value of the mantissa data of the third data and the mantissa data of the shifted second data.

15. The MAC operator of clause 13 or clause 14, further comprising:
a second multiplexer configured to receive the first output data and the second output data, to output the first output data based on the first signal, and to output the second output data based on the second signal.

16. The MAC operator of any of clauses 13 to 15, further comprising:

an exclusive OR (XOR) operation unit configured to receive sign data of the second data and the sign data of the third data, and to generate sign data of the second output data; and
a second adder configured to receive exponent data of the second data and exponent data of the third data, and to generate exponent data of the second output data.

17. The MAC operator of any of clauses 12 to 16, wherein
the first AND operation unit is configured to output the first data based on the first binary value being a first value, and output data in which all bit values are '0' based on the first binary value being a second value, different from the fist value.

18. The MAC operator of any of clauses 12 to 17, wherein
the data of the first data type is fixed-point data, and the data of the second data type is floating point data.

19. A matrix multiplier, comprising:

a data buffer configured to receive a first input vector and a second input vector from an external memory, and to receive a plurality of scale factors and a plurality of binary vectors as weight vectors from the external memory;
an input parser configured to receive the plurality of scale factors and the plurality of binary vectors, to output the plurality of scale factors and the plurality of binary vectors together with a first signal of a first level, receive the second input vector, and to output the second input vector together with a first signal of a second level different from the first level;
an input vector scaler configured to generate a first scaled input vector based on a multiplication operation on the first input vector and on the plurality of scale factors;
a first data type converter configured to receive the first scaled input vector, to extract a first exponent among the exponents of each of first plurality of scaled input elements included in the first scaled input vector, and to convert the data type of the first scaled input vector to fixed-point based on the first exponent; and
a MAC operator configured to accumulate the first scaled input vector based on the binary values of the plurality of binary vectors and to generate a fixed-point output matrix when receiving the first signal of the first level.

20. The matrix multiplier of clause 19, wherein

the MAC operator is configured to perform a matrix dot-product operation on the first input vector and the second input vector and generate a first output matrix in response to receiving the first signal of the second level,
and the matrix multiplier further comprises:
a second data type converter configured to receive the fixed-point output matrix and the first output matrix, to output a second output matrix generated by converting the data type of the fixed-point output matrix to floating point as output data based on the first exponent in response to receiving the first signal of the second level, and to output the first output matrix as output data in response to receiving the first signal of the first level.

**Claims**

1. A matrix multiplier, comprising:

    an input vector scaler configured to generate a scaled input matrix based on a first input matrix and on a plurality of scale factors;
    a first data type converter configured to convert the data type of the scaled input matrix to fixed-point and to generate a fixed-point input matrix;
    a multiplication and accumulation operator array configured to receive the fixed-point input matrix and a plurality of binary vectors, to generate a fixed-point output matrix based on the fixed-point input matrix and on the plurality of binary vectors, to receive the first input matrix and a second input matrix, and to generate a first output matrix based on the first input matrix and the second input matrix; and
    a second data type converter configured to convert the data type of the fixed-point output matrix to a floating point and to generate a second output matrix.

2. The matrix multiplier of claim 1, further comprising:
an input parser configured to receive the second input matrix, the plurality of scale factors and the plurality of binary vectors as weight matrix from outside, to sequentially provide the plurality of scale factors to the input vector scaler, to sequentially provide the second input matrix and the plurality of binary vectors to the multiplication and accumulation operator array, and to provide a first signal that control the multiplication and accumulation operator array and the second data type converter.

3. The matrix multiplier of claim 2, wherein

    the multiplication and accumulation operator array comprises
    a first multiplication and accumulation operator configured to receive a first input vector of the first input matrix and a first input vector of the second input matrix, and to receive a first fixed-point input vector of the fixed-point input matrix and a first binary value of the plurality of binary vectors.

4. The matrix multiplier of claim 3, wherein
the first multiplication and accumulation operator is configured to:

    perform a multiplication operation on the first binary value of the plurality of binary vectors and on the first fixed-point input vector and generate a first fixed-point output element of the fixed-point output matrix, the multiplication operation on the first binary value and the generating a first fix-point output element based on the first signal having a first level,
    and perform a multiplication operation on the first input vector of the first input matrix and the first input vector of the second input matrix and generate a first output element of the first output matrix, the multiplication operation on the first input vector and the generating the first output element based on the first signal having a second level different from the first level.

5. The matrix multiplier of claim 4, wherein
   the first multiplication and accumulation operator comprises:

   a first circuit configured to output sign data of the first output element;
   a second circuit configured to output exponent data of the first output element; and
   a third circuit configured to generate the first fixed-point output element based on the first signal having the first level, and output mantissa data of the first output element based on the first signal having the second level.

6. The matrix multiplier of claim 5, wherein
   the third circuit comprises:

   a first multiplexer configured to receive mantissa data of a first input element of the first input vector and the first fixed-point input element, and to output the first fixed-point input element based on the first signal;
   a first AND operation unit configured to perform an AND operation on the first binary values of the plurality of binary vectors and the first fixed-point input element; and
   an addition unit configured to add the output data of the first AND operation unit.

7. The matrix multiplier of claim 5 or claim 6, wherein

   the first multiplication and accumulation operator further comprises
   a multiplexer configured to receive the first output element and the first fixed-point output element, and to output the first fixed-point output element as output data of the first multiplication and accumulation operator based on the first signal.

8. The matrix multiplier of any of claims 3 to 7, wherein
   the multiplication and accumulation operator array further comprises:

   a second multiplication and accumulation operator configured to receive the first input vector of the first input matrix, a second input vector of the second input matrix, the first fixed-point input vector, and a second binary value of the plurality of binary vectors; and
   a third multiplication and accumulation operator configured to receive the second input vector of the first input matrix, the first input vector of the second input matrix, the second fixed-point input vector of the fixed-point input matrix, and the first binary value of the plurality of binary vectors.

9. The matrix multiplier of any of claims 2 to 8, wherein

   the first data type converter comprises
   a first data type convert circuit configured to receive a first plurality of scaled input vectors of the scaled input matrix, to extract a largest first exponent among the exponents of each of a first plurality of scaled input elements included in the first plurality of scaled input vectors, and to convert the data type of each of the first plurality of scaled input elements into a fixed-point based on the first exponent.

10. The matrix multiplier of claim 9, wherein
    the second data type converter is configured to:
    receive a first fixed-point output vector of the fixed-point output matrix and the first signal, and convert the data type of each of a first plurality of fixed-point output elements included in the first fixed-point output vector to a floating point based on the first exponent.

11. A multiply-and-accumulate (MAC) operator, comprising:

    a first multiplexer configured to receive a first data of a first data type and mantissa data of a second data of a second data type different from the first data type, output the first data based on a first signal, and output the mantissa data of the second data based on a second signal different from the first data;
    a first AND operation unit configured to receive a plurality of binary values and perform an AND operation of a first binary value among the plurality of binary values and the first data; and

an adder configured to add output data of the first AND operation unit and to output a first output data of the first data type.

12. The MAC operator of claim 11, wherein

the first AND operation unit is configured to further receive mantissa data of third data of the second data type, and to perform an AND operation of a first bit value of the mantissa data of the third data and the mantissa data of the second data,
and the adder is configured to output mantissa data of a second output data of the second data type.

13. The MAC operator of claim 12, further comprising:

a first shifter configured to shift the mantissa data of the second data by 1 bit;
a second multiplexer configured to receive a fourth data of the first data type and mantissa data of the shifted second data, to output the fourth data based on the first signal, and to output mantissa data of the shifted second data based on the second signal; and
a second AND operation unit configured to perform an AND operation of a second binary value among the plurality of binary values and the fourth data, and to perform an AND operation of a second bit value of the mantissa data of the third data and the mantissa data of the shifted second data.

14. The MAC operator of claim 12 or claim 13, further comprising:
a second multiplexer configured to receive the first output data and the second output data, to output the first output data based on the first signal, and to output the second output data based on the second signal.

15. A matrix multiplier, comprising:

a data buffer configured to receive a first input vector and a second input vector from an external memory, and to receive a plurality of scale factors and a plurality of binary vectors as weight vectors from the external memory;
an input parser configured to receive the plurality of scale factors and the plurality of binary vectors, to output the plurality of scale factors and the plurality of binary vectors together with a first signal of a first level, receive the second input vector, and to output the second input vector together with a first signal of a second level different from the first level;
an input vector scaler configured to generate a first scaled input vector based on a multiplication operation on the first input vector and on the plurality of scale factors;
a first data type converter configured to receive the first scaled input vector, to extract a first exponent among the exponents of each of first plurality of scaled input elements included in the first scaled input vector, and to convert the data type of the first scaled input vector to fixed-point based on the first exponent; and
a MAC operator configured to accumulate the first scaled input vector based on the binary values of the plurality of binary vectors and to generate a fixed-point output matrix when receiving the first signal of the first level.

# FIG. 1

100

$$YM$$
$$\{\overrightarrow{Y_1}, \overrightarrow{Y_2}, \overrightarrow{Y_3}, ... \overrightarrow{Y_m}\}$$

$$WM \ (\alpha, \overrightarrow{B})$$

$$XM$$
$$\{\overrightarrow{X_1}, \overrightarrow{X_2}, \overrightarrow{X_3}, ... \overrightarrow{X_h}\}$$

MATMUL

$$ZM$$
$$\{\overrightarrow{Z_1}, \overrightarrow{Z_2}, \overrightarrow{Z_3}, ... \overrightarrow{Z_h}\}$$

$$PM$$
$$\{\overrightarrow{P_1}, \overrightarrow{P_2}, \overrightarrow{P_3}, ... \overrightarrow{P_h}\}$$

FIG. 2

$$WM = \begin{bmatrix} \begin{bmatrix} w_{11} & \cdots & w_{1m} \\ w_{21} & \cdots & w_{2m} \\ \vdots & \ddots & \vdots \\ w_{n1} & \cdots & w_{nm} \end{bmatrix} \end{bmatrix} \begin{matrix} \sim \overrightarrow{w_{r1}} \\ \vdots \\ \sim \overrightarrow{w_{rn}} \end{matrix} \Bigg\} \quad \overrightarrow{w_{ri}} \approx \sum_{k=1}^{R} \left( \alpha_{k\_ri} \times \overrightarrow{B_{k\_ri}} \right)$$

## FIG. 3

Sign (1bit)

Exponent (8bits)

Mantissa (23bits)

FIG. 4

400

S_IN1[31]
S_IN2[31]

E_IN1[30:23]
E_IN2[30:23]

M_IN1[22:0]
M_IN2[22:0]

IN1[31:0]
IN2[31:0]

410
401
411

421
-Bias — 420
423

MTS_MUL — 430

E_OUT[7:0]

M_OUT[47:0]

NORMALIZER — 440

OUT[31]

OUT[30:0]

ADDER — 450

402

ACCUMULATOR — 460

EP 4 592 823 A1

# FIG. 5

<u>430</u>

M_OUT[47:0]

FIG. 6

# FIG. 7

EP 4 592 823 A1

EP 4 592 823 A1

# FIG. 8

FIG. 9

EP 4 592 823 A1

# FIG. 10

| | Sign<br>(S) | | | Exponent<br>(EXP) | | | Mantissa<br>(MTS) | | |
|---|---|---|---|---|---|---|---|---|---|

$X'_{11}$   | 1 | 0 | ... | 1 | 1 | 1 | ... | 0 | 1 |

$X'_{12}$   | 0 | 0 | ... | 0 | 0 | 1 | ... | 0 | 0 |

$\overrightarrow{X'_1}$

$X'_{13}$   | 1 | 0 | ... | 0 | 1 | 1 | ... | 0 | 1 |

$X'_{1n}$   | 0 | 0 | ... | 1 | 0 | 1 | ... | 1 | 1 |

"Extract maximum exponent"

EXP1

FIG. 11

MTS of $x'_{11}$
[MTSa]

| 1 | 0 | 1 | 0 | 0 | ... | 0 | 1 | 1 | 0 | 1 |

sft1

MTS of $x'_{11\_fxp}$
[MTSb]

| 0 | 0 | 0 | 0 | 1 | 1 | 1 | ... | 0 | | 0 | 1 | 1 | 0 | 1 |

Mantissa of $x'_{11\_fxp}$     "Cutoff / Rounding"

# FIG. 12

INPUT PARSER —640

$\overrightarrow{b_1}\ for$
$\{\overrightarrow{B_{1\_r1}}, \overrightarrow{B_{2\_r1}}, ..., \overrightarrow{B_{R\_rn}}\}$

$\overrightarrow{Y_1}$

$\overrightarrow{b_2}\ for$
$\{\overrightarrow{B_{1\_r1}}, \overrightarrow{B_{2\_r1}}, ..., \overrightarrow{B_{R\_rn}}\}$

$\overrightarrow{Y_2}$

$\overrightarrow{b_m}\ for$
$\{\overrightarrow{B_{1\_r1}}, \overrightarrow{B_{2\_r1}}, ..., \overrightarrow{B_{R\_rn}}\}$

$\overrightarrow{Y_m}$

—670

$\overrightarrow{X_1}$

MAC — 671

MAC — 672

MAC — 67m

MR1

$\overrightarrow{X'_{1\_fxp}}$

$\overrightarrow{X_2}$

MAC

MAC

MAC

$\overrightarrow{X'_{2\_fxp}}$

MR2

MC1

MC2

MCm

$\overrightarrow{X_h}$

MAC

MAC

MAC

$\overrightarrow{X'_{1\_fxp}}$

MRh

$p_{11\_fxp}$  $z_{11}$

$p_{12\_fxp}$  $z_{12}$

$p_{1m\_fxp}$  $z_{1m}$

$p_{h1\_fxp}$  $z_{h1}$

$p_{h2\_fxp}$  $z_{h2}$

$p_{hm\_fxp}$  $z_{hm}$

EP 4 592 823 A1

# FIG. 13

$$\underbrace{\begin{bmatrix} x_{11} & x_{12} & \cdots & x_{1n} \\ x_{21} & x_{22} & \cdots & x_{2n} \\ \vdots & \vdots & \ddots & \vdots \\ x_{h1} & x_{h2} & \cdots & x_{hn} \end{bmatrix}}_{\substack{\text{INPUT MATRIX 1} \\ \underline{\text{(XM)}}}} \times \underbrace{\begin{bmatrix} y_{11} & y_{12} & \cdots & y_{1m} \\ y_{21} & y_{22} & \cdots & y_{2m} \\ \vdots & \vdots & \ddots & \vdots \\ y_{n1} & y_{n2} & \cdots & y_{nm} \end{bmatrix}}_{\substack{\text{INPUT MATRIX 2} \\ \underline{\text{(YM)}}}} = \underbrace{\begin{bmatrix} z_{11} & z_{12} & \cdots & z_{1m} \\ z_{21} & z_{22} & \cdots & z_{2m} \\ \vdots & \vdots & \ddots & \vdots \\ z_{h1} & z_{h2} & \cdots & z_{hm} \end{bmatrix}}_{\substack{\text{OUTPUT MATRIX 1} \\ \underline{\text{(ZM)}}}}$$

1311

1412  1422

EP 4 592 823 A1

FIG. 14

## FIG. 15

$b_1$ for $\overrightarrow{B_{k\_rn}}$     $b_2$ for $\overrightarrow{B_{k\_rn}}$     $b_m$ for $\overrightarrow{B_{k\_rn}}$

$b_1$ for $\overrightarrow{B_{k\_r2}}$     $b_2$ for $\overrightarrow{B_{k\_r2}}$     $b_m$ for $\overrightarrow{B_{k\_r2}}$

$b_1$ for $\overrightarrow{B_{k\_r1}}$     $b_2$ for $\overrightarrow{B_{k\_r1}}$     $b_m$ for $\overrightarrow{B_{k\_r1}}$

$(X_{1n} \times \alpha_{k\_rn})_{fxp}$ $\cdots$ $(X_{12} \times \alpha_{k\_r2})_{fxp}$ $(X_{11} \times \alpha_{k\_r1})_{fxp}$

$\overrightarrow{X'_{1\_fxp}}$

MAC —671    MAC —672 $\cdots$ MAC —67m

—PER1

$p_{11\_fxp}$     $p_{12\_fxp}$     $p_{1m\_fxp}$

# FIG. 16

# FIG. 17

<u>671</u>

$\vec{X_1}$  $\vec{Y_1}$  $\overrightarrow{X'_{1\_fxp}}$  $b_1 for \vec{B}$

671_4

671_3    671_2    671_1

MULTIPLICATION PORTION

671_5    ACCUMULATION PORTION

$p_{11\_fxp}$

$z_{11}$

SEL    671_6

OUT

# FIG. 18

Sign
[S]

Mantissa
[MTS]

$p_{11\_fxp}$ | 1 | 0 | ... | 1 | 1 |

Sign
[S]

Exponent
[EXP]

Mantissa
[MTS]

$p_{11}$ | 1 | 0 | ... | 1 | 1 | 0 | ... | 1 | 1 | 0 | 0 | ... | 0 |

"Insert EXP1"

"Insert '0' bits"

# FIG. 19

# FIG. 20

# FIG. 21

Europäisches
Patentamt
European
Patent Office
Office européen
des brevets

# EUROPEAN SEARCH REPORT

**Application Number**

EP 24 20 6895

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | Kim Yulhwa ET AL: "WINNING BOTH THE ACCURACY OF FLOATING POINT ACTIVATION AND THE SIMPLICITY OF INTEGER ARITHMETIC", <br><br> , <br> 28 February 2023 (2023-02-28), XP093242728, <br> Retrieved from the Internet: <br> URL:https://openreview.net/pdf?id=z92lBy1e hjI <br> * figures 1, 3, 5, 8 * <br> * Sections 3.1, 4.1 * <br> * Equation (1) * <br> - - - - - | 1-15 | INV. <br> G06F7/544 <br> G06F7/483 |
| A | GUNHO PARK ET AL: "LUT-GEMM: Quantized Matrix Multiplication based on LUTs for Efficient Inference in Large-Scale Generative Language Models", <br> ARXIV.ORG, CORNELL UNIVERSITY LIBRARY, 201 OLIN LIBRARY CORNELL UNIVERSITY ITHACA, NY 14853, <br> 15 April 2023 (2023-04-15), XP091485175, <br> * figure 5 * <br> * Sections 2, 3 * <br> - - - - - | 1-15 | |

**TECHNICAL FIELDS SEARCHED (IPC)**

G06F

The present search report has been drawn up for all claims

| Place of search | Date of completion of the search | Examiner |
|---|---|---|
| Munich | 24 March 2025 | Winkelbauer, Andreas |